# EUROPEAN PATENT APPLICATION

(11) **EP 2 613 620 A1**
(43) Date of publication of application: **10.07.2013**
(21) Application number: 11821712.4
(22) Date of filing: 29.08.2011
(51) Int. Cl.: H05K 9/00, C01B 31/02

(54) **SHEET MATERIAL AND PRODUCTION METHOD OF SAME**

(30) Priority: 03.09.2010 JP 2010197347
(71) Applicant: Asahi Organic Chemicals Industry Co., Ltd., Nobeoka-shi, Miyazaki 882-8688 (JP); The Nisshin OilliO Group, Ltd., Tokyo 104-8285 (JP); Sanwa Yushi Co., Ltd., Tendou-city, Yamagata 994-0044 (JP)
(72) Inventor: KANEIWA, Toshihiko, Niwa-gun Aichi 480-0105 (JP); TAKAHASHI, Takehiko, Tendou-city Yamagata 994-0044 (JP); TAKAHASHI, Takeshi, Tendou-city Yamagata 994-0044 (JP); GOTOU, Hiroyuki, Tokyo 104-8285 (JP); SHINOHARA, Go, Tokyo 104-8285 (JP); KUNO, Noriyasu, Tokyo 104-8285 (JP); IIZUKA, Hiroshi, Yamagata-shi Yamagata 990-0044 (JP)
(74) Representative: Hodsdon, Stephen James
(86) International application number: PCT/JP2011/069406
(87) International publication number: WO 2012/029696

(57) **Abstract**

PROBLEM

To effectively utilize plant residue such as soybean hulls, rapeseed meal, rice bran, rice husk, and cacao husk.

SOLUTION

When forming sheet material from a mixture of burned plant material and fibrous material by a wet-process sheet production method, the burned plant material is one of a burned material of rice husk, a burned material of rice bran, a burned material of soybean hulls, a burned material of inner skin of peanut, a burned material of conduit side wall portion of seed plant or a burned material of cacao husk, and the fibrous material is one of a organic fiber derived from thermoplastic resin including polyolefin consisting of polyethylene and polypropylene, polyester, polyamide, vinyl chloride, polyacrylonitrile, polyvinyl chloride and aramid, a fiber derived from thermosetting resin including kynol, a natural fiber including cotton, wool, etc., a semisynthetic fiber, an inorganic fiber including glass fiber and carbon fiber, a metal fiber including iron, copper, stainless steel and steel, a metalized fiber with electroless plating applied on short fibers including synthetic resin and inorganic material, furthermore, a combination of these short fibers.

## Description

### FIELD OF THE INVENTION

The present inventions is related to a sheet material and its production method, particularly, a sheet material and its production method using a burned plant material such as burned material of rice husk, burned material of rice bran, burned material of soybean hulls, and burned material of cacao husk.

### BACKGROUND OF THE INVENTION

Patent Document 1 discloses the idea to use industrially a burned plant material obtained by burning a plant including grain residue such as soybean hulls, rapeseed meal, rice bran, and rice husk.

Patent Document 1: JPA2010-161337

### DISCLOSURE OF THE INVENTION

### PROBLEM TO BE SOLVED BY THE INVENTION

By the way, in recent years, reuse is discussed from a viewpoint of ecology for grain residue such as soybean hulls, rapeseed meal, rice bran, and rice husk. In particular, as disclosed in Patent Document 1, interesting data have been obtained in a burned material of grain residue mainly from a viewpoint of electrical characteristics.

The present invention makes it a problem to use effectively grain residue such as soybean husk, rapeseed meal, rice bran, and rice hulls.

### MEANS OF SOLVING THE PROBLEMS

The present inventors burned grain residue such as soybean hulls, rapeseed meal, rice bran, rice husk, and cacao husk, and produced a sheet material using the burned plant material and fibrous material, then, measured electrical characteristics, etc. As a result, it was found that the sheet material has excellent electromagnetic shielding characteristic and electromagnetic wave absorption characteristic.

The sheet material of the present invention to solve the above problem is formed by a wet-process sheet production method from a mixture of burned plant material and fibrous material. In addition, the production method of a sheet material of the present invention is to form a sheet by wet-process sheet production using the sheet making slurry obtained by mixing fibrous material and burned plant material in water.

As burned plant material, burned materials of soybean hulls, rapeseed meal, rice bran, rice husk, soybean chaff, inner skin of peanut, conduit side wall portion of seed plant, cacao husk, etc. are included. And it was found that electromagnetic shielding characteristic, etc. are changed by changing mixing ratio between those burned materials and fibrous material, or by changing paper weight in gsm of sheet material, or by mixing of metal filler, matrix, etc. Said mixing ratio, etc. can be determined according to the frequency band of electromagnetic wave to be shielded, etc. In addition, the mixing ratio between burned plant material and fibrous material to optimize electromagnetic shielding characteristic, etc. was also found.

As a result of the study of the present inventors, it was found that the type of burned plant material to be a material of sheet material can be selected according to the application of sheet material. For example, in order to produce a sheet material having an excellent electromagnetic shielding characteristic, for example, a burned material of soybean hulls or a burned material of cacao husk can be selected as a material. In addition, in order to produce a sheet material having an excellent electromagnetic wave absorption characteristic, for example, a burned material of cacao husk, a burned material of rice husk or a burned material of rice bran can be selected as a material. Therefore, in order to produce a sheet material having an excellent electromagnetic shielding characteristic and an excellent electromagnetic wave absorption characteristic, a burned material of cacao husk including spiral portion, etc. can be selected as a material.

In addition, regarding the fibrous materials of sheet material of the present invention, since it is acceptable if they can even immobilize a burned plant material, these types are particularly unquestioned. As an example, they are shown below, (1) organic fiber derived from thermoplastic resin including polyolefin consisting of polyethylene and polypropylene, polyester, polyamide, vinyl chloride, polyacrylonitrile, polyvinyl chloride, aramid, etc., (2) fiber derived from thermosetting resin including kynol, etc., (3) natural fiber including cotton, wool, cellulose pulp, etc., (4) semisynthetic fiber, (5) inorganic fiber including glass fiber, carbon fiber, etc., (6) metal fiber including iron, copper, stainless, steel, etc., (7) furthermore, combination of these short fibers. These fibrous materials can also serve as a reinforcement material of sheet material.

In order to mold the sheet material, the matrices consisting of powdery or fibrous thermosetting resin or thermoplastic resin are added at the same time when performing sheeting, or, the matrices consisting of thermosetting resin or thermoplastic resin of liquid state may be impregnated into a sheet material

In order to produce a sheet material having electromagnetic shielding effect in a wide frequency band, as described below, since a burned plant material can cover a relatively low frequency band, it is better to use fibrous or powdery metal filler having excellent electromagnetic shielding effect in a high frequency band. Also, a metal filler may be fibrous or powdery organic filler or inorganic filler which is applied metal plating.

### EMBODYMENT OF THE INVENTION

Referring to drawings, embodiments according to the present invention are described hereinafter.

### (Embodiment 1)

In this embodiment, although a case that a burned material of cacao husk is used as a material of sheet material is mainly explained as a example, a case that a burned material of soybean hulls, a burned material of rapeseed meal, a burned material of rice bran, a burned material of rice husk, a burned material of soybean chaff, a burned material of inner skin of peanut or a burned material of conduit side wall portion of seed plant is used as a material of sheet material is also same. In addition, a production method of burned material of soybean hulls, etc. is the same as a production method of burned material of cacao husk.

In addition, the cacao husk in this embodiment is mainly the skin itself which covers plural cocoa beans contained in cacao, and it may be called cacao shell. In this embodiment, although various experiments and evaluations are performed with the contents described above, the cacao husk in this embodiment includes not only the cacao husk but also the mixture of the cacao husk and the skin covering cocoa beans.

In this embodiment, for example, at a temperature of approx. 600 [°C] to 3000 [°C], using a carbonization apparatus such as a holding furnace or a rotary kiln, the burned material of cacao husk is obtained by burning cacao husk for about 3 hours at the attained temperature in an inert gas atmosphere with nitrogen gas, etc. or in a vacuum condition, selectively. Then, the burned material of cacao husk is pulverized selectively and then sieved using a mesh, for example, of a 106 µm wire mesh.

As a result, about 80 % of the entire burned material of cacao husk becomes 85 µm or below. In this case, the median diameter is, for example, approx. 25 µm. Hereinafter, in the case that the burning temperature is clearly specified as 900 [°C], the median diameter when the burned material of cacao husk is pulverized is approx. 25 µm.

The median diameter is measured by a laser diffraction particle size analyzer, for example, SALD-7000 manufactured by SHIMADZU Corporation. In this embodiment, a burned material of cacao husk whose median diameter is approx. 10 µm to approx. 60 µm may be used, and a burned material whose minimum median diameter is approx. 1 µm by those further selective pulverizing may also be used.

In addition, pulverizing herein refers to a pulverization of a pre-pulverizing material to reduce its median diameter by about one decimal order. Therefore, it refers that a median diameter of 30 µm before pulverization is pulverized to 3 µm. However, pulverizing does not refer to exactly reducing the median diameter before pulverization by approx. one decimal order, and it also includes pulverizing to reduce the median diameter before pulverization to 1/5 - 1/20. In this embodiment, the pulverization is carried out so that the median diameter after pulverization becomes 1 µm at the smallest.

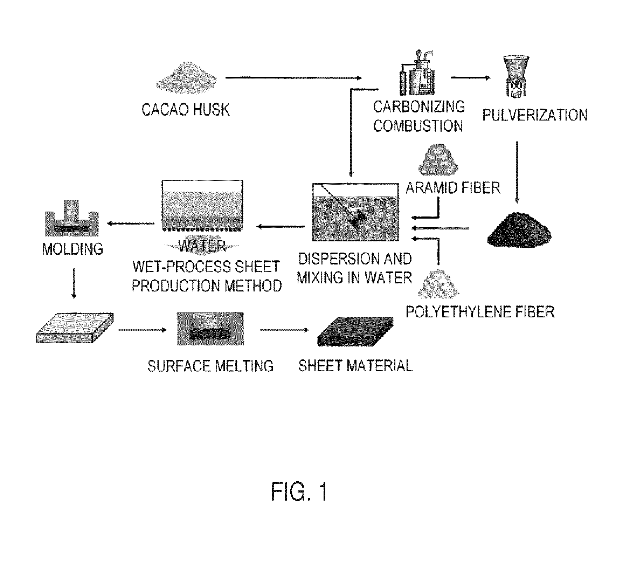

Fig. 1 shows a schematic production process diagram of the sheet material using burned material of cacao husk. First, after repeated crushing against cacao husk until the size of crushed material becomes about 1.0mm to 3.0 mm by a known crusher, it is set in a carbonization apparatus. At this time, selectively, when it is impregnated with phenolic resin such as resol-type phenolic resin, the strength and carbon content of burned material of cacao husk can be improved. However, please note that said impregnation itself is not essential for producing the sheet material of this embodiment.

Second, the cacao husk is heated at the rate of approx. 2 [°C] per minute in a nitrogen gas atmosphere to reach a prescribed temperature such as 700 [°C] - 1500 [°C] (for example, 900 [°C]). Then the carbonizing burning treatment is performed for several hours to several weeks, for example, at the attained temperature.

Next, the fibrous material such as, aramid fiber and polyethylene fiber is introduced in a mixer having high shear property such as a juicer mixer, a pulper mixer, and a henschel mixer with plenty of water, and is dispersed and mixed. In addition, the fibrillation treatment of fibrous material may be possible using a defibration device such as a beater and a refiner in order to improve the tangle of fibrous material and the particle collection property of fibrous material in the case of sheet material.

Then, water dispersed fibrous material is introduced in an agitated vessel with propeller impeller, furthermore, a burned cacao husk with pulverization or without pulverization is introduced. The pulverization condition is as described above. In addition, the mixing ratio between burned cacao husk and aramid fiber, etc. will be described below with various measurement results. At this time, if necessary, various additives such as metal filler may be introduced in the agitated vessel.

And then, rotating the propeller impeller, the burned cacao husk and the various additives are dispersed and mixed in water in which a fibrous material is dispersed. At this time, the rotational speed of the propeller impeller may be about 50 [rpm] to 500 [rpm] so as to maintain the carbonaceous shape of burned cacao husk.

Then, adding a particle collection agent in the agitated vessel, the sheet making slurry of 0.01 % to 1.0 % concentration is obtained by agitation and mixing at low speed. The particle collection agent may be used in typical paper-making process of sheet making, or, in water treatment, it is also referred as a flocculant.

Next, the sheet making slurry is subjected to wet-process sheet production. More specially, for example, the total amount of sheet making slurry obtained is introduced in a box-type paper machine of about 300 [mm] x 300 [mm] covered with 100 mesh square sheet making wire mesh, then, a wet state sheet is obtained by performing the discharge filtration of water and the suctioning, squeezing and dewatering from the bottom of the paper machine. And then, it is dried in a hot air circulation dryer at about 100 °C.

It is cut into an appropriate size and filled in a metal mold which is heated to about 130 °C, and then, it is pressed under the conditions of about 20 [kgf/cm²] as molding pressure and about 5 minutes as molding time in a compression molding machine, after that, when it is cooled to about 100 °C under pressurized condition, the sheet material of the present embodiment can be obtained. The heating temperature may be equal to or higher than the curing temperature of thermosetting resin or the melting temperature of thermoplastic resin to be a matrix. And the molding pressure may also be selected appropriately depending on the target thickness of sheet material. In addition, as a production process of sheet material, it is not mandatory to include the compression molding using a metal mold, for example, it can also be formed by a roll press.

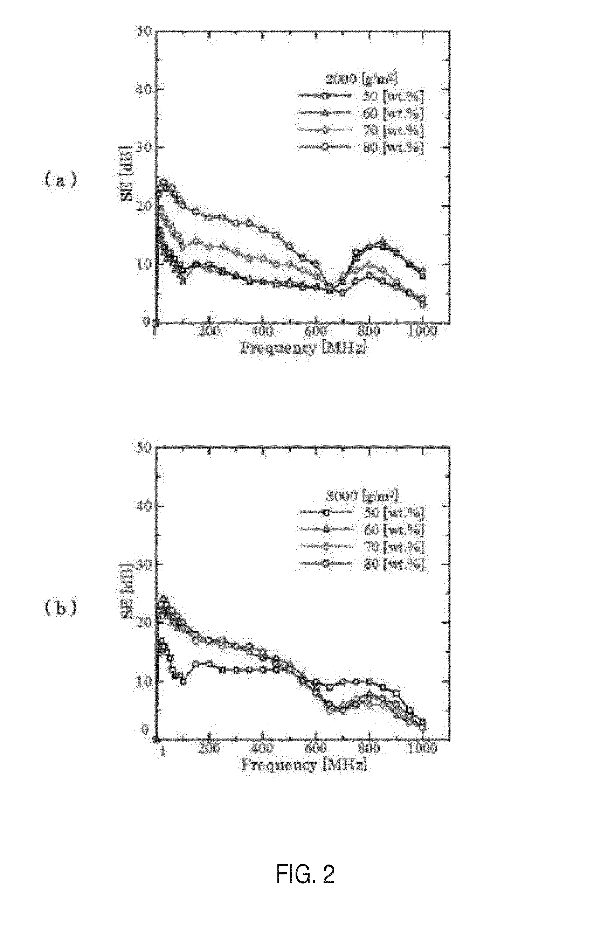

Fig. 2 shows charts indicating the measurement results of the electromagnetic shielding characteristics of the sheet material produced through a pulverization process of burned material of cacao husk. The lateral axis and vertical axis of Fig. 2 indicate frequency [MHz] and electromagnetic shielding effectiveness (SE) [dB] respectively. In addition, these electromagnetic shielding characteristics were obtained by using Shield Material Evaluator (TR17301A manufactured by Advantest Corporation) and Spectrum Analyzer (TR4172 manufactured by Advantest Corporation) at Yamagata Research Institute of Technology, Okitama Branch.

Fig. 2 (a) shows the electromagnetic shielding characteristic in the case that the paper weight in gsm of burned material of cacao husk is 2000 [g/m²]. Fig. 2 (b) shows the electromagnetic shielding characteristic in the case that the paper weight in gsm of burned material of cacao husk is 3000 [g/m²]. Incidentally, when the plane size of sheet material is about 300 [mm] x 300 [mm], the thickness is about 3.0 [mm] in the case that the paper weight in gsm of sheet material is 2000 [g/m²], the thickness is about 4.5 [mm] in the case that the paper weight in gsm of sheet material is 3000 [g/m²].

First, upon measuring the electromagnetic shielding characteristics of sheet material, the sheet material that the mixing ratios of burned material of cacao husk against the entire sheet material are 50 [wt. %], 60 [wt. %], 70 [wt. %] and 80 [wt. %] is produced respectively.

In Fig. 2 (a), if the mixing ratio of burned material of cacao husk is increased more, it can be seen that the electromagnetic shielding effectiveness of sheet material is increased more. Here, as the electromagnetic shielding effectiveness, generally, 20 [dB] or above which can shield electromagnetic wave 99% or above is one indicator for a practical rough standard. The sheet material of the present embodiment is 20 [dB] or above in the frequency range 100 [MHz] or below in general in the case that the mixing ratio of burned material of cacao husk against the entire sheet material is 80 [wt. %]. Therefore, it is understood that the sheet material of the present embodiment is excellent electromagnetic shielding characteristic.

In addition, when compared with Fig. 2 (a) and Fig. 2 (b), if the paper weight in gsm will be 3000 [g/m²], the electromagnetic shielding effectiveness is increased in each of case where the mixing ratios of burned material of cacao husk against the entire sheet material are 50 [wt. %], 60 [wt. %] and 70 [wt. %]. Therefore, if the mixing ratio of burned material of cacao husk against the entire sheet material becomes 80 [wt. %], it is unlikely that there is a dramatic change in the electromagnetic shielding characteristic even if the paper weight in gsm is 2000 [g/m²], 3000 [g/m²] or is increased more.

In the case that the paper weight in gsm is 3000 [g/m²], if the mixing ratio of burned material of cacao husk against the entire sheet material is 60[wt. %] or above, the electromagnetic shielding characteristic of sheet material is not much difference. Therefore, in this case, it is unlikely that there is a dramatic change in the electromagnetic shielding characteristic even if the mixing ratio of burned material of cacao husk against the entire sheet material is increased more.

That is, when the total amount of burned material of cacao husk in the sheet material has reached a certain amount, subsequently, it is unlikely that the electromagnetic shielding characteristic is improved even if the total amount of burned material of cacao husk is increased more. Therefore, in the case that the sheet material is produced using burned material of cacao husk, it is possible that the burned material of cacao husk can be reasonable amount and no-wasted amount.

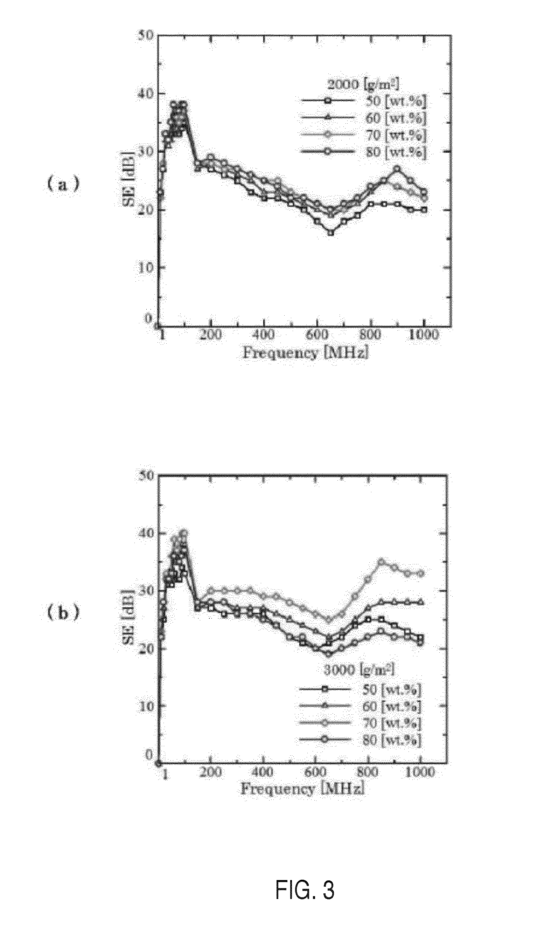

Fig. 3 shows charts indicating the measurement results of the electromagnetic shielding characteristics of the sheet material produced without going through a pulverization process of burned material of cacao husk, it is corresponding to Fig. 2. In addition, all measurement methods of electromagnetic shielding characteristic described hereinafter are the same as described above.

As it is obvious from Fig. 3, surprisingly, the electromagnetic shielding effectiveness is significantly increased overall in case of without going through a pulverization process. That is, even if the paper weight in gsm is 2000 [g/m²] or 3000 [g/m²), in the case of 600[MHz] or below which is the frequency band of the upper measurement limit shown in Fig. 3, even if the mixing ratio of burned material of cacao husk against the entire sheet material is any of 50 [wt. %], 60 [wt. %], 70 [wt. %] or 80 [wt. %], the electromagnetic shielding effectiveness is approximately more than 20 [dB], even from seeing at the frequency band and even from seeing at the mixing ratio, the electromagnetic shielding effectiveness is significantly increased overall.

From this, the sheet material produced without going through a pulverization process against burned material of cacao husk is possible to obtain relatively excellent electromagnetic shielding characteristic, even if the mixing ratio of burned material of cacao husk against the entire sheet material is kept low relatively or even if the paper weight in gsm of sheet material is reduced relatively. In other words, the sheet material produced without going through a pulverization process against burned material of cacao husk is possible to produce a sheet material inexpensively because it only needs to use a small amount of burned material of cacao husk.

According to Fig. 3 (b), in the mixing ratio as a measurement target, in the case that the mixing ratio of burned material of cacao husk against the entire sheet material is 70 [wt. %], the electromagnetic shielding characteristic is best. That is, with regard to the electromagnetic shielding characteristic, it can be said that the mixing ratio of burned material of cacao husk against the entire sheet material is generally 70 [wt. %].

Fig. 4 shows charts indicating the measurement results of the electromagnetic shielding characteristics of the sheet material produced through a pulverization process of burned material of soybean hulls, it is corresponding to Fig. 2.

Fig. 5 shows charts indicating the measurement results of the electromagnetic shielding characteristics of the sheet material produced without going through a pulverization process of burned material of soybean hulls, it is corresponding to Fig. 3.

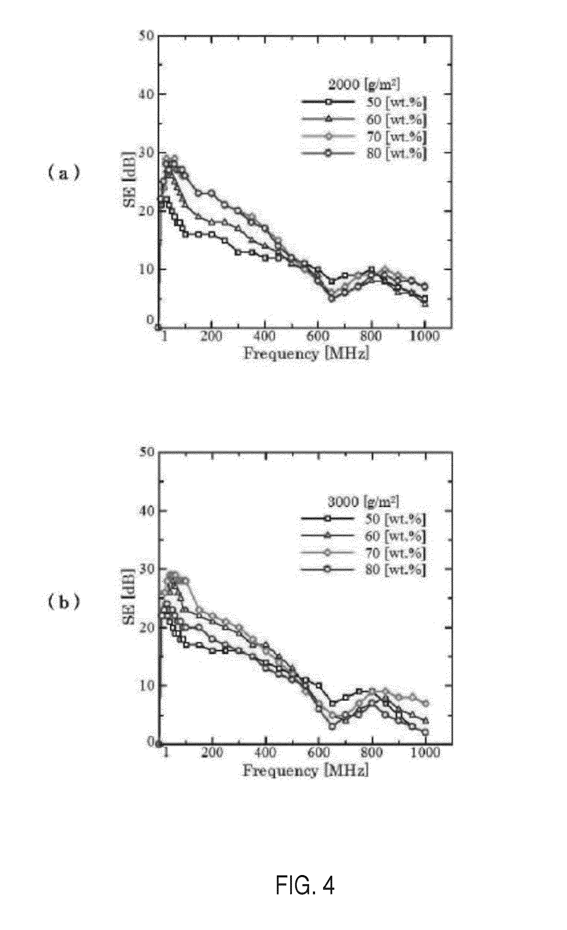

In contrast to Fig. 4, Fig. 5 and Fig. 2, Fig. 3 respectively, although the electromagnetic shielding effectiveness is different, some common points can be found. More specially, they are common in these points that, in the case of without going through a pulverization process, the electromagnetic shielding level of sheet material is high, the mixing ratio of burned plant material against the entire sheet material is likely to be good at generally 70 [wt. %], the paper weight in gsm of sheet material is good to be the greater, in the view point of electromagnetic shielding characteristic.

In addition, in the sheet material produced using rice husk without pulverization, the electromagnetic shielding effectiveness 20 [dB] or above is confirmed at the frequency band 100 [MHz] or below. On the other hand, in the case of sheet material produced using rice bran, even if the best condition, it is able to produce only the sheet material in which the electromagnetic shielding effectiveness is slightly more than 20 [dB].

For the above reasons, in order to produce a sheet material particularly excellent in electromagnetic shielding characteristic, it can be seen that the burned material of cacao husk and the burned material of soybean hulls are better to be used as material. However, regarding the electromagnetic shielding member which is generally commercially available, most of electromagnetic shielding effectiveness falls in the range of 5 [dB] to 25 [dB]. According to this, the electromagnetic shielding effectiveness of 20 [dB] used as an index in the present embodiment is of a higher level. Even in any of the burned material of rice husk, rice bran, cacao husk or soybean hulls, the electromagnetic shielding effectiveness 5 [dB] or above is confirmed at the frequency band 600 [MHz] or below. Therefore, the sheet material of the present embodiment is able to achieve the same level as those of the electromagnetic shielding member in commercial level, even though using any burned plant material which is the measurement object here.

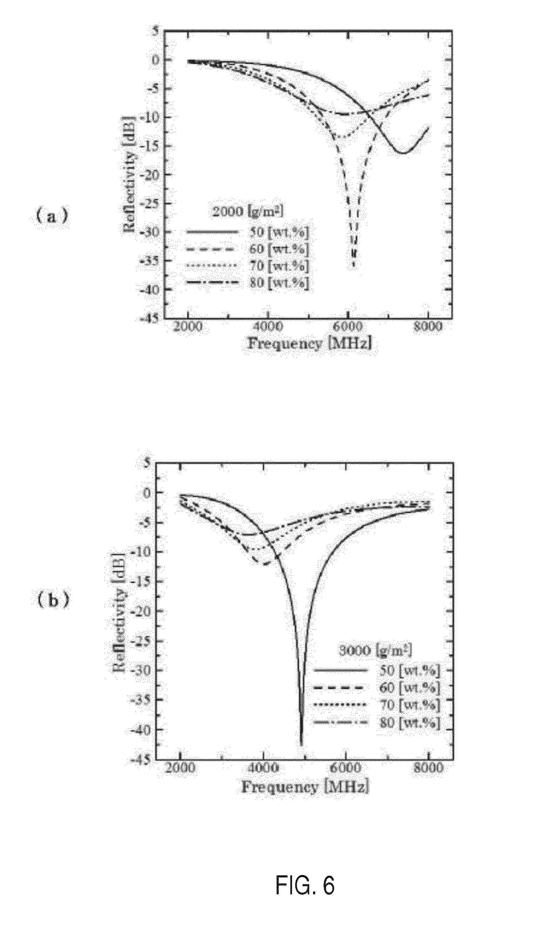

Fig. 6 shows charts indicating the measurement results of the electromagnetic wave absorption characteristic of the sheet material produced through a pulverization process of burned material of cacao husk. Fig. 6 (a) shows the measurement results of the electromagnetic wave absorption characteristic in the case that the paper weight in gsm of burned material of cacao husk is 2000 [g/m²], Fig. 6 (b) shows the measurement results of the electromagnetic wave absorption characteristic in the case that the paper weight in gsm is 3000 [g/m²].

For measuring the electromagnetic wave absorption characteristics shown in Fig. 6, the sheet material with a size of 300 [mm] x 300 [mm] is mounted on a metallic plate with the same size, and the sheet material is irradiated with the incident waves of frequencies plotted in Fig. 6 so as to measure the energy of the reflected waves from the sheet material, thus the energy difference between the incident wave and the reflected wave, that is, the electromagnetic wave absorption (energy loss) is calculated. The measurement is performed based on the arch test method by using an arch type electromagnetic wave absorption measuring apparatus.

AS shown in Fig. 6 (a), in the case that the paper weight in gsm of burned material of cacao husk is 2000 [g/m²], at the time that the mixing ratio of burned material of cacao husk against the entire sheet material is 60 [wt. %], the electromagnetic wave absorption with a peak around 6000 [MHz] can be confirmed. For the electromagnetic wave absorption, in general, one indicator is whether it exceeds the level of -20 [dB]. Then, since the peak is about -35 [dB], it is found that the absorption amount is significantly higher than the indicator.

As shown in Fig. 6 (b), in the case that the paper weight in gsm of burned material of cacao husk is 3000 [g/m²], at the time of the mixing ratio of burned material of cacao husk against the entire sheet material is 50 [wt. %], the electromagnetic wave absorption with a peak around 5000 [MHz] can be confirmed. Since the electromagnetic wave absorption is about -42 [dB], it is found that the absorption amount is significantly higher than the indicator.

According to Fig. 6 (a) and Fig. 6 (b), by appropriate selection of the paper weight in gsm and the mixing ratio of burned material of cacao husk against the entire sheet material, the electromagnetic wave absorbing sheet material targeted a desired frequency band can be produced.

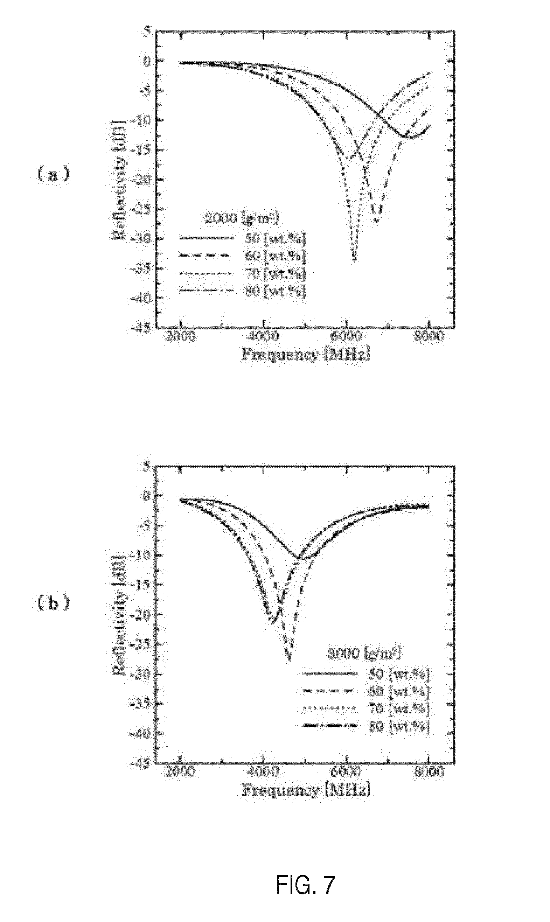

Fig. 7 shows charts indicating the measurement results of the electromagnetic wave absorption characteristic of the sheet material produced through a pulverization process of the burned material of rice husk. Fig. 7 (a) shows the measuring results of the electromagnetic wave absorption characteristic in the case that the paper weight in gsm of burned material of rice husk is 2000 [g/m²], Fig. 7 (b) shows the measuring results of the electromagnetic wave absorption characteristic in the case that the paper weight in gsm is 3000 [g/m²]. This measurement is performed based on the arch test method.

As shown in Fig. 7 (a), in the case that the paper weight in gsm of burned material of rice husk is 2000 [g/m²], when the mixing ratio of burned material of rice husk against the entire sheet material is 70 [wt. %], the electromagnetic wave absorption with a peak around 6000 [MHz] can be confirmed. Since the electromagnetic wave absorption is about -35 [dB], it is found that the absorption amount is significantly higher than the indicator. In addition, when the mixing ratio of burned material of rice husk against the entire sheet material is 60 [wt. %], the electromagnetic wave absorption with a peak around 6500 [MHz] can be confirmed. Since the electromagnetic wave absorption is about -27 [dB], it is found that the absorption amount significantly higher than the indicator.

As shown in Fig. 7 (b), in the case that the paper weight in gsm of burned material of rice husk is 3000 [g/m²], when the mixing ratio of burned material of rice husk against the entire sheet material is 60 [wt. %], the electromagnetic wave absorption with a peak around 4500 [MHz] can be confirmed. Since the electromagnetic wave absorption is about -28 [dB], it is found that the absorption amount is significantly higher than the indicator.

According to Fig. 7 (a) and Fig. 7 (b), by appropriate selection of the paper weight in gsm and the mixing ratio of burned material of rice husk against the entire sheet material, the electromagnetic wave absorbing sheet material targeted a desired frequency band can be produced.

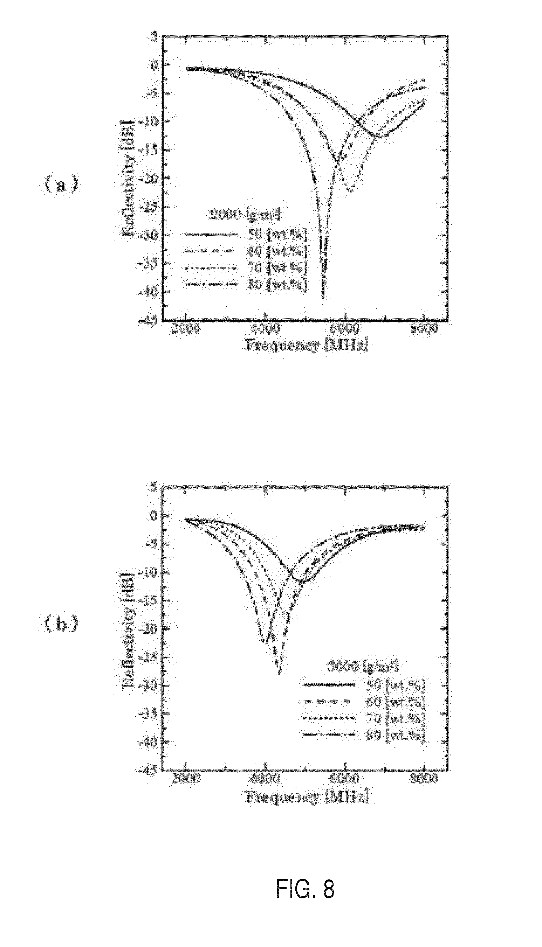

Fig. 8 shows charts indicating the measurement results of the electromagnetic wave absorption characteristic of the sheet material produced by using the burned material of rice bran. Fig. 8 (a) shows the measurement results of the electromagnetic wave absorption characteristic in the case that the paper weight in gsm of burned material of rice bran is 2000 [g/m²], Fig. 8 (b) shows the measurement results of the electromagnetic wave absorption characteristic in the case that the paper weight in gsm is 3000 [g/m²].

As shown in Fig. 8 (a), in the case that the paper weight in gsm of burned material of rice bran is 2000 [g/m²], when the mixing ratio of burned material of rice bran against the entire sheet material is 80 [wt. %], the electromagnetic wave absorption with a peak around 5200 [MHz] can be confirmed. Since the electromagnetic wave absorption is about -40 [dB], it is found that the absorption amount is significantly higher than the indicator.

As shown in Fig. 8 (b), in the case that the paper weight in gsm of burned material of rice bran is 3000 [g/m²], when the mixing ratio of burned material of rice husk against the entire sheet material is 60 [wt. %], the electromagnetic wave absorption with a peak around 4200 [MHz] can be confirmed. Since the electromagnetic wave absorption is about -28 [dB], it is found that the absorption amount is significantly higher than the indicator.

According to Fig. 8 (a) and Fig. 8 (b), by appropriate selection of the paper weight in gsm and the mixing ratio of burned material of rice bran against the entire sheet material, the electromagnetic wave absorbing sheet material targeted a desired frequency band can be produced.

According to Fig. 6 to Fig. 8 explained above, based on the type of burned plant material used as a material of sheet material, since the frequency band where the electromagnetic wave absorption becomes a peak is different, it may be selected that what kind of burned plant material is decided as a material, or, it may be used by mixing them by selecting properly plural burned plant materials.

In addition, in order to study the conduction characteristic of the sheet material using each of burned material of cacao husk, rice husk, rice bran and soybean hulls, the specific volume resistivity of each sheet material is measured. In the case of burned material of rice husk, the specific volume resistivity is approx. 10² [Ω· cm] to 10³ [Ω· cm]. Furthermore, it is found that the specific volume resistivity hardly changes by the presence or absence of the pulverization process against the burned material of rice husk.

In addition, the specific volume resistivity of each sheet material is measured a low resistivity meter (Loresta-GP, MCP-610 manufactured by Mitsubishi Chemical Co. Ltd.). More specifically, against any 9 areas of the sheet material, by pressing a probe of low resistivity meter, flows current from the probe to the sheet material, the specific volume resistivity is measured by measuring the potential difference between both sides of sheet material.

In the case of burned material of rice bran, the specific volume resistivity is approx. 10² [Ω·cm] to 10⁵ [Ω·cm]. In the case of burned material of soybean hulls, the specific volume resistivity is approx. 10¹ [Ω· cm] to 10³ (Ω· cm]. Furthermore, it is found that the specific volume resistivity hardly changes by the presence or absence of the pulverization process against the burned material of soybean hulls.

The burned material of cacao husk is seen differences in specific volume resistivity by the presence or absence of the pulverization process, the specific volume resistivity through the pulverization process is approx. 10¹ [Ω·cm] to 10² [Ω·cm], the specific volume resistivity without going through the pulverization process is approx. 10⁰ [Ω·cm] to 10¹ [Ω·cm], it is found that the specific volume resistivity will be increased by the presence of the pulverization process.

The sheet material of the present embodiment can be suitably used for the following applications,
(1) Electromagnetic shielding material related to an electronic device including communication terminal such as a mobile phone and PDA (Personal Digital Assistant), an electronic device such as a microwave oven, and an electronic substrate used to them,
(2) Electromagnetic shielding material related to an inspection equipment such as an electronic device (including a shielding box),
(3) Electromagnetic shielding material related to near ETC gate, inside tunnel and inside underground parking lot for suitable intercommunication between vehicles,
(4) Electromagnetic shielding material related to building materials such as roof material, floor material or wall material, as well as work shoes, and work clothes,
(5) Electromagnetic shielding material related to cushioning material comprising electromagnetic wave absorption effect using a soft state object before hot pressing, and further, a helmet used it inside, an automobile door equipped it inside,
(6) A battery pack cover for a car, and, an undercover for a car.

As a result of this, there are advantageous effects of making it possible to eliminate a cause for adverse impact on human body from the electromagnetic waves generated from mobile phones etc. or power cables etc. around houses, to provide a light-weight shield box, and to provide work shoes etc. having anti-static capability.

Furthermore, a soft state object before hot pressing which can be said as a precursor of the sheet material of the present embodiment can also be used. In this case, for example, when it is used as building material, it is going to have thermal retaining property, and there is an advantage of being easy to use for clothing.

Then, as a material of the sheet material where both of electromagnetic shielding characteristic and electromagnetic wave absorption characteristic are excellent, focusing on cacao husk, the following measurement, etc. were performed.

(1) Component analysis of cacao husk before and after burning,
(2) Tissue observation of cacao husk before and after burning,
(3) Conductivity test for burned material of cacao husk.

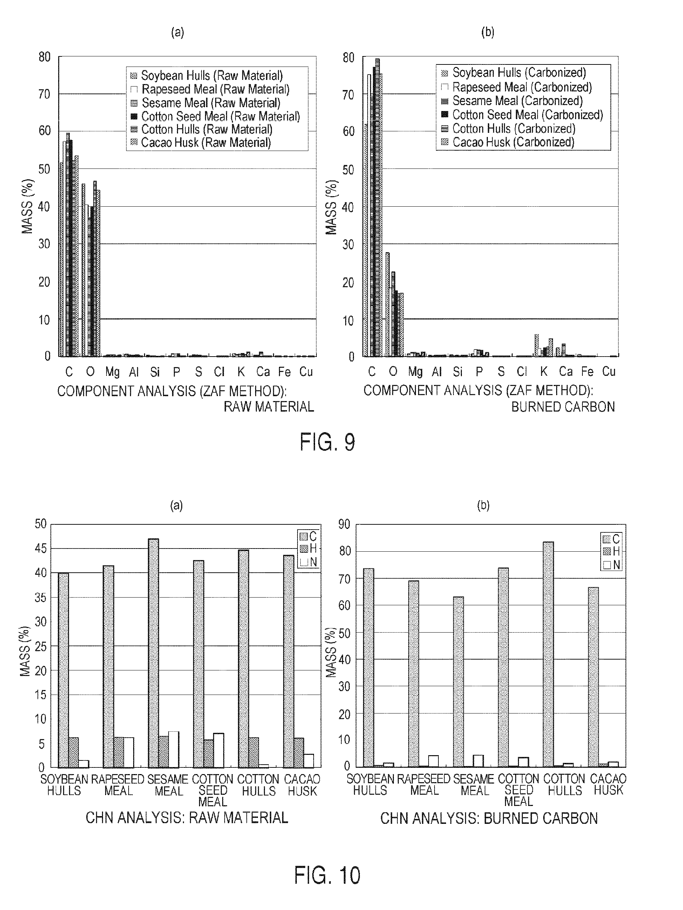

Fig. 9 (a) shows a chart indicating the result of the component analysis based on the ZAF quantitative analysis method for cacao husk before burning. Fig. 9 (b) shows a chart indicating the result of the component analysis based on the ZAF quantitative analysis method for cacao husk shown in Fig. 9 (a) after burning.

In addition, the results of the component analysis for soybean hulls, rapeseed meal, sesame meal, cotton seed meal, cotton hulls are also shown in Fig. 9 (a) and Fig. 9 (b), for comparison.

Although the production conditions for the burned material of cacao husk etc. are as shown in Fig. 1, the "prescribed temperature" and "median diameter" were respectively set to 900 [°C] and approx. 10 µm to approx. 60 µm. Since it has been said that the ZAF quantitative analysis method is quantitatively less reliable regarding C, H and N elements in comparison with the organic micro-elemental analysis method, an analysis based on the organic micro-elemental analysis method is also performed separately in order to perform a highly reliable analysis regarding C, H and N elements.

The cacao husk before burning shown in Fig. 9 (a) has relatively low percentage of "C" and has relatively high percentage of "O". On the other hand, the cacao husk after burning shown in Fig. 9 (b) has average percentage of "C" and has low percentage of "O". Thus, regarding cacao husk, the increase of "C" can be seen, because the percentage of "C" increases while the percentage of "O" decreases by burning treatment.

Fig. 10 (a) shows a chart indicating the result of the component analysis based on the organic micro-elemental analysis method corresponding to Fig. 9 (a). Fig. 10 (b) shows a chart indicating the result of the component analysis based on the organic micro-elemental analysis method corresponding to Fig. 9 (b).

As seen in Fig. 10 (a) and Fig. 10 (b), the ratios of organic elements included in the burned materials of six kinds of plants can generally be evaluated as similar to each other. However, since rapeseed meal, sesame meal and cotton seed meal have the common feature of being oil meal, it is perceived that those charts are similar to each other. Specifically, it is perceived that the percentage of "N" is relatively high while the increase rate in "C" before and after burning is relatively low.

In contrast, since soybean hulls and cotton hulls have the common feature of being hulls, it is perceived that those charts are similar to each other. Specifically, it is perceived that the percentage of "N" is relatively low while the increase rate in "C" before and after burning is relatively high. On the other hand, a cacao husk has relatively low percentage of "C" while has relatively high increase rate in "N" before and after burning. In addition, in terms of "C", cotton hulls is the highest (approx. 83%), while sesame meal is the lowest (approx. 63%).

In addition, according to the component analysis for the cacao husk, the results of the component analysis (organic micro-elemental analysis) of cacao husk before burning had the carbon component, hydrogen component and nitrogen component of respectively approx. 43.60%, approx. 6.02% and approx. 2.78%. In contrast, the results of the component analysis(organic micro-elemental analysis) of cacao husk after burning had the carbon component, hydrogen component and nitrogen component of respectively approx. 65.57%, approx. 1.12% and approx. 1.93%. Furthermore, the specific volume resistivity of the burned material of cacao husk was 4.06x10⁻¹² Ω· cm.

Furthermore, according to the component analysis based on the organic micro-elemental analysis method, it is perceived that the cacao husk etc. before burning, in general, are essentially rich in the carbon component. In contrast, it is perceived that, regarding cacao husk etc. after burning, the carbon percentage is increased by burning.

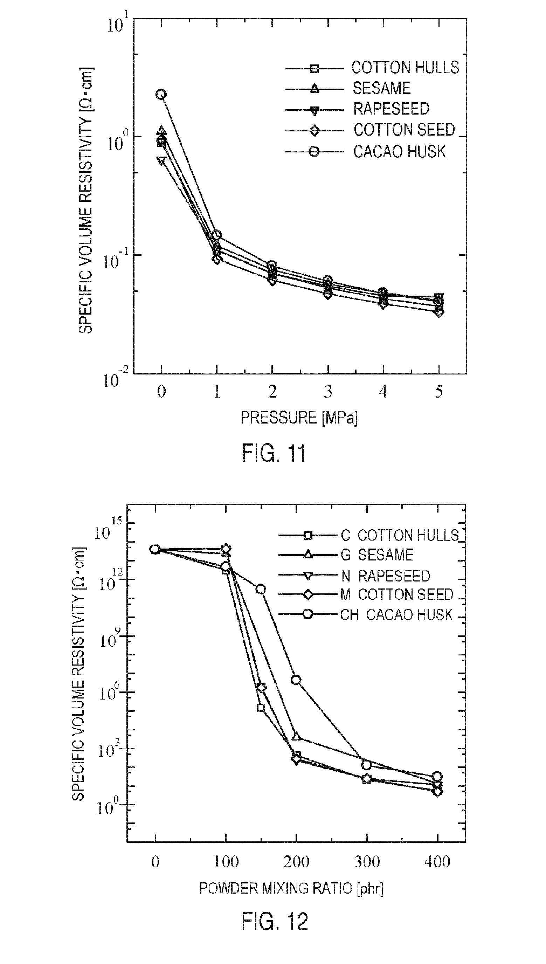

Fig. 11 shows a chart indicating the test results of the conductivity test regarding the burned material of cacao husk after pulverization. The lateral axis and vertical axis of Fig. 11 respectively represent the pressure [MPa] applied to the burned material of cacao husk and the specific volume resistivity [Ω·cm]. In addition, the test results for cotton hulls, sesame meal, rapeseed meal, cotton seed meals are also shown in Fig. 11, for reference.

The method employed is that, 1g of the powdered "burned material of cacao husk" as a test object is put in a cylindrical container with an inner diameter of approx. 25Φ, and a cylindrical brass with a diameter of approx. 25Φ is aligned to the opening part of the above container, and then a press machine (MP-SC manufactured by Toyo Seiki Seisaku-Sho, Ltd.) is used to apply pressure to the burned material of cacao husk by pressing via the brass from 0 [MPa] to 4 [MPa] or 5 [MPa] with an increment of 0.5 [MPa] so that the specific volume resistivity is measured by bringing the side part and bottom part of the brass into contact with a probe of a low resistivity meter (Loresta-GP MCP-T600 manufactured by Mitsubishi Chemical Co. Ltd.) while the burned material of cacao husk is pressured.

When a cylindrical container with approx. 10Φ was used instead of the cylindrical container with approx. 25Φ, and a cylindrical brass with a diameter of approx. 10Φ was used instead of the cylindrical brass with a diameter of approx. 25Φ, and when the rest of the conditions were the same as above, an equivalent test result was obtained by the conductivity test.

According to the test result shown in Fig. 11, it is found that the burned material of cacao husk has a characteristic which reduces its specific volume resistivity (that is, increasing the conductivity) by applying a pressure of 0.5 [MPa] or above, for example, and as the pressure increases.

The specific volume resistivity of cotton hulls is 3.74x10⁻² [Ω·cm], the specific volume resistivity of sesame meal is 4.17x10⁻² [Ω·cm], the specific volume resistivity of rapeseed meal is 4.49x10⁻² [Ω·cm], the specific volume resistivity of cotton seed meals is 3.35x10⁻² [Ω·cm] and the specific volume resistivity of cacao husk is 4.06x10⁻² [Ω·cm].

In fact, although there is exactly three times difference, for example, between the specific volume resistivity of 1.00x10⁻¹ [Ω·cm] and the specific volume resistivity of 3.00x10⁻¹ [Ω·cm], such a degree of exactness is not required in the measurement results of the specific volume resistivity as it is clearly known by those skilled in the art. Thus, since the specific volume resistivity of 1.00x10⁻¹ [Ω·cm] and the specific volume resistivity 3.00x10⁻¹ [Ω·cm] both are on the same order of "10⁻¹", please note that those can be evaluated as equivalent to each other.

Fig. 12 shows a chart indicating the relationship between the content ratio of the burned material of cacao husk kneaded into ethylene propylene diene terpolymer and the specific volume resistivity. That is, in this case, as a comparative example of the sheet material, the thing kneaded the burned material of cacao husk into ethylene propylene diene terpolymer is produced. The lateral axis and vertical axis of Fig. 12 respectively represent the content ratio [phr] of the burned material of cacao husk and the specific volume resistivity [Ω·cm]. In addition, for comparison, Fig. 12 also shows those of the electromagnetic shielding member using the respective burned materials of cotton hulls, sesame meal, rapeseed meal and cotton seed meals. The plotted numeric in Fig 12 is an average of measurements at 9 arbitrarily chosen points in the electromagnetic shielding member (same applies hereinafter).

As shown in Fig. 12, each specific volume resistivity of cacao husk etc. had a measurement result similar to each other. Each specific volume resistivity of cacao husk etc. is also similar to the specific volume resistivity of soybean hulls.

Regarding only to the respective burned materials of soybean hulls, rapeseed meal, sesame meal, cotton seed meal and cotton hulls, when the content ratio of the burned plant material against rubber is set to 200 [phr] or above, it is found that the specific volume resistivity significantly decreases in all cases in contrast to the case that said content ratio is set to 150 [phr] or below. In contrast, regarding the burned materials of cacao husk, it is found that the specific volume resistivity significantly decreases linearly to the increase of the content ratio against the rubber.

Regarding the burned materials of cacao husk etc. according to this embodiment, the bulk specific gravity has been measured in conformity to JIS K-1474. The bulk specific gravity of rapeseed meal, sesame meal, cotton seed meal, cotton hulls and cacao husk were approx. 0.6 g/ml to 0.9 g/ ml, approx. 0.7 g/ml to 0.9 g/ ml, approx. 0.6 g/ml to 0.9 g/ ml, approx. 0.3 g/ml to 0.5 g/ ml, and approx. 0.3 g/ml to 0.5 g/ ml respectively. The kinds of hulls (cotton hulls and cacao husk) are a relatively bulky.

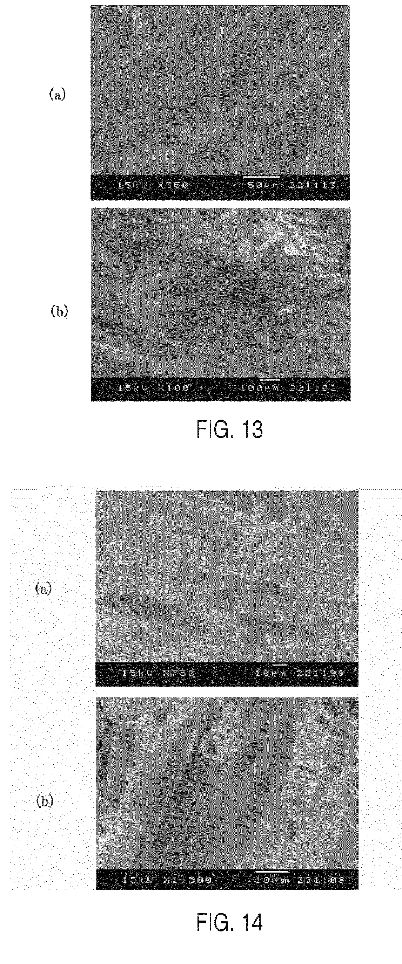

Fig. 13 and Fig. 14 show SEM pictures of cacao husk before burning. Fig. 13 (a), Fig. 13 (b), Fig. 14 (a), and Fig. 14 (b) respectively show a picture of the outer skin taken at 350-fold magnification, a picture of the inner skin taken at 100-fold magnification, a picture of the inner skin taken at 750-fold magnification, and a picture of the inner skin taken at 1500-fold magnification.

As shown in Fig. 13 (a), the outer skin of cacao husk before burning is a form like the surface of a limestone. In contrast, as shown in Fig. 13 (b), the inner skin of cacao husk before burning is a form like the fibrous.

Interestingly, as shown in Fig. 14 (a) and Fig. 14 (b), the inner skin of cacao husk before burning is equipped with spiral portion when the fibrous part is expanded. In addition, the diameter of spiral portion is visible to 10 µm to 20 µm in general.

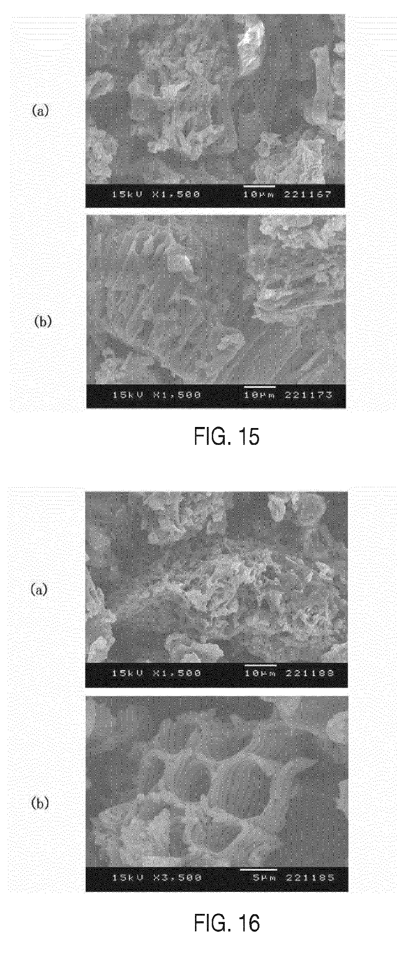

Fig. 15 and Fig. 16 show SEM pictures of cacao husk burned without distinguishing by the inner skin and the outer skin. Fig. 15 (a), Fig. 15 (b), and Fig. 16 (a) respectively show a picture of the burned material taken at 1500-fold magnification, and Fig. 16 (b) shows a picture of the burned material taken at 3500-fold magnification.

From Fig. 15 (a) and Fig. 16 (b), it is confirmed that the fibrous portion looked at the inner skin of cacao husk before burning is remaining also in the burned material of cacao husk. In addition, as for the size of the burned material, the diameter of spiral portion seems to be shrunk to approximately 5 µm to 10 µm. Moreover, from Fig. 15 (b) and Fig. 16 (a), it is confirmed that the burned material of cacao husk is a variegated porous structure.

The spiral portion is not confirmed in soybean hulls, rapeseed meal, sesame meal, cotton seed meal, cotton hulls and soybean chaffs as stated above. Therefore, such a form has a high possibility of being peculiar to a cacao husk. On the other hand, since the conduit side wall portion etc. of seed plant, such as lotus roots and pumpkins, further, the inner skin of peanuts etc. also contain a spiral portion, the effect which is obtained in the case using the burned material of cacao husk can be expected. From this, the scope of the present invention is intended to include those using any burned plant material containing a spiral portion.

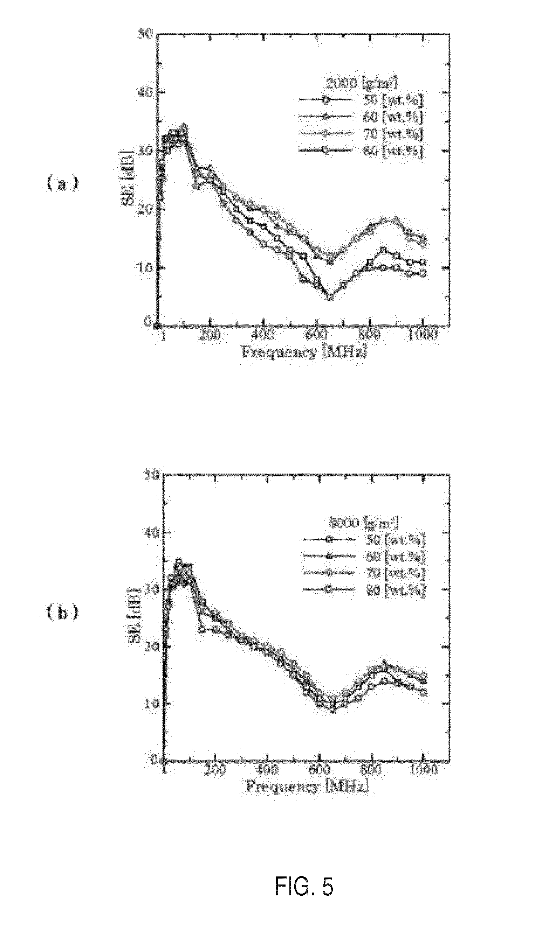

Here, when a pulverization treatment is performed against the burned material of cacao husk, or it is kneaded into rubber, there is a possibility that the spiral portion may be crushed. And, when comparing the electromagnetic shielding characteristic of the sheet material through the pulverization treatment of the burned material of cacao husk shown in Fig. 2 and the electromagnetic shielding characteristic of the sheet material without going through the pulverization treatment shown in Fig. 3, there is a significant difference in the electromagnetic shielding effectiveness. On the other hand, when comparing Fig. 4 and Fig. 5 showing the electromagnetic shielding characteristic according to the burned material of soybean hulls, there is no much difference in the electromagnetic shielding effectiveness.

From this, it can be considered that the spiral portion found in the burned material of cacao husk contributes to convert the electromagnetic wave energy into other energy efficiently. As in the present embodiment, without performing the pulverization treatment against the burned material of cacao husk, the sheet material using the wet-process sheet production method which can produce while leaving well the spiral portion can be obtained excellent electrical properties that rubber material would not be obtained. Saying in addition, the sheet material using the wet-process sheet production method has the advantage which can leave own structure of each of the burned plant material.

### (Embodiment 2)

Although the sheet material using the burned material of cacao husk has been explained mainly in Embodiment 1 of the present invention, a sheet material added the stainless fiber which is a metal filler against various burned plant materials will be explained in Embodiment 2 of the present invention. In addition, a stainless fiber is an example of a metal filler, and a metal filler which can be used in the sheet material of the present embodiment is not limited to a stainless fiber.

Incidentally, the stainless fiber used in the present embodiment is Naslon (registered trademark) CHOP6 manufactured by Nippon Seisen Co., Ltd., except that the stainless fiber is mixed together at the time of mixture of burned plant material and aramid fiber, the production method of sheet material of the present embodiment is the same as that of Embodiment 1. In addition, the burning temperature of each burned plant material is set to 900 [°C].

**Table 1**

| Category | 1 st category | | 2nd category | | 3rd category | | | |
|---|---|---|---|---|---|---|---|---|
| Burned carbon | Pulverized powder RBC, RHC, SHC | 50wt % | Pulverized powder RBC, RHC, SHC | 25wt.% | Pulverized powder (150~250 *µ*m) | | | |
| | No pulverized piece RHC-L, SHC-L | | No pulverized piece RHC-L, SHC-L | | 37.5 | 25.0 | 12.5 | 0 wt.% |
| SUS fiber | 0 | | 25 | | 12.5 | 25.0 | 37.5 | 50.0 wt.% |
| Paper weight [g/ m²] | 2000 | | | | | | | |

**Table 2**

| 4th category | | | |
|---|---|---|---|
| Composition (product name) | CHC-L formed sheet | SUS fiber formed sheet | SUS fiber + CHC-L formed sheet |
| Burned carbon | CHC-L 50 wt.% | 0 | CHC-L 25 wt.% |
| SUS fiber | 0 | 50 wt.% | 25 wt.% |

Table 1 and Table 2 are tables showing the configuration of the sheet material according to Embodiment 2 of the present invention. As shown in Table 1 and Table 2, the configuration of the sheet material of the present embodiment is roughly divided into 4 categories.

As for 1^{st} category, the thing which the mixing ratio of each of the followings against the entire sheet material is 50 [wt. %] is prepared. That is, the sheet material according to 1^{st} category is a sheet material which is not mixed with stainless (SUS) fiber against the above-mentioned various burned plant materials.
Burned material of rice bran performed pulverization treatment (RBC), and
Burned material of rice husk performed pulverization treatment (RHC), and
Burned material of soybean hulls performed pulverization treatment (SHC), and
Burned material of rice husk without performing pulverization treatment (RHC-L), and
Burned material of soybean hulls without performing pulverization treatment (SHC-L).

As for 2^{nd} category, the thing which the mixing ratio of each of the followings against the entire sheet material is 25 [wt. %] and the mixing ratio of stainless (SUS) fiber against the entire sheet material is 25 [wt. %] is prepared. That is, the sheet material according to 2^{nd} category is a sheet material which is mixed with stainless (SUS) fiber against the various burned plant materials.
Burned material of rice bran performed pulverization treatment (RBC), and
Burned material of rice husk performed pulverization treatment (RHC), and
Burned material of soybean hulls performed pulverization treatment (SHC), and
Burned material of rice husk without performing pulverization treatment (RHC-L), and
Burned material of soybean hulls without performing pulverization treatment (SHC-L)

As for 3^{rd} category, the things which the mixing ratios of the burned material of cacao husk performed the pulverization treatment under the condition to fit the size of 150 [µm] to 200 [µm] majority (CHC) and the stainless (SUS) fiber against the entire sheet material are respectively 37.5 [wt. %] and 12.5 [wt. %], 25 [wt. %] and 25 [wt. %], 12.5 [wt. %] and 37.5 [wt. %], 0 [wt. %] and 50.0 [wt. %] are prepared. That is, the sheet material according to 3^{rd} category is a sheet material which stainless (SUS) fiber is selectively mixed against the burned material of cacao husk performed the pulverization treatment.

As for 4^{th} category, the things which the mixing ratios of the burned material of cacao husk without performing the pulverization treatment (CHC-L) and the stainless (SUS) fiber against the entire sheet material are respectively 50.0 [wt. %] and 0 [wt. %], 0 [wt. %] and 50 [wt. %], 25 [wt. %] and 25 [wt. %] are prepared. That is, the sheet material according to 4^{th} category is a sheet material which stainless (SUS) fiber is selectively mixed against the burned material of cacao husk without performing the pulverization treatment.

Incidentally, as for those belonging to any of 1^{st} category to 4^{th} category, the paper weight in gsm is set to 2000 [g/m²].

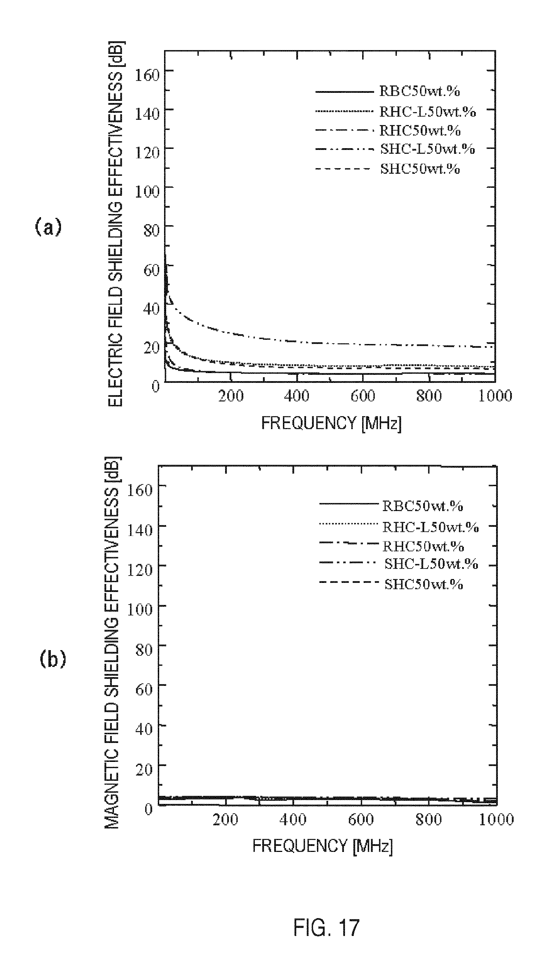

Fig. 17 is figures showing the measurement results of the electromagnetic shielding effectiveness of the sheet material according to 1^{st} category, that is, the sheet material is not mixed with stainless (SUS) fiber against various burned plant material. This measurement has been performed by KEC method, the lateral axis and vertical axis of Fig. 17 (a) respectively represent the frequency [MHz] and the electric field shielding effectiveness [dB]. Further, the lateral axis and vertical axis of Fig. 17 (b) respectively represent the frequency [MHz] and the magnetic field shielding effectiveness [dB].

According to Fig. 17 (a), the sheet material which has the highest electric field shielding effectiveness is produced by mixing 50 [wt. %] burned material of soybean hulls without performing pulverization treatment (SHC-L), and, the highest electric field shielding effectiveness is a value of approx. 20 [dB] or above up to about 1000 [MHz].

Then, the sheet material produced by mixing 50 [wt. %] burned material of rice husk without performing pulverization treatment (RHC-L) and the sheet material produced by mixing 50 [wt. %] burned material of soybean hulls performed pulverization treatment (SHC) are approximately the same value, the electric field shielding effectiveness is a value of approx. 7 [dB] or above up to frequencies of about 1000 [MHz].

In addition, the sheet material produced by mixing 50 [wt. %] burned material of rice bran performed pulverization treatment (RBC) and the sheet material produced by mixing 50 [wt. %] burned material of rice husk performed pulverization treatment (RHC) are approximately the same value, the electric field shielding effectiveness is a value of approx. 5 [dB] or above up to frequencies of about 1000 [MHz].

On the other hand, according to Fig. 17 (b), in any sheet material, excellent value as the magnetic field shielding effectiveness is not obtained.

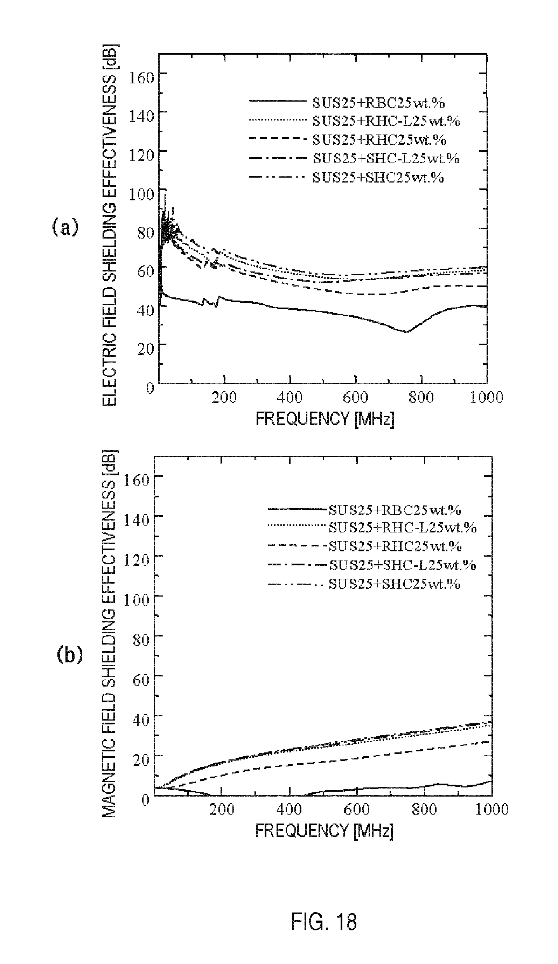

Fig. 18 is figures showing the measurement results of the electromagnetic shielding effectiveness of the sheet material according to 2^{nd} category. That is, the sheet material is mixed with stainless (SUS) fiber against various burned plant material. Fig. 18 is corresponding to Fig. 17.

As apparent from Fig. 18 (a), when compared to Fig. 17 (a), generally, it is found that the electric field shielding effectiveness is improved. Except for the mixture which the burned material of rice bran performed pulverization treatment (RBC) and the stainless (SUS) fiber are at 25 [wt. %] each, and the mixture which the burned material of rice husk performed pulverization treatment (RHC) and the stainless (SUS) fiber are at 25 [wt. %] each, the electric field shielding effectiveness is a value of approx. 58 [dB] or above up to frequencies of about 1000 [MHz], and in the low frequency range 50 [MHz] or below, the electric field shielding effectiveness of 80 [dB] to 100 [dB] at the maximum is obtained.

In addition, in the mixture that the burned material of rice husk performed pulverization treatment (RHC) and the stainless (SUS) fiber are at 25 [wt. %] each, the electric field shielding effectiveness is a value of approx. 50 [dB] or above up to frequencies of about 1000 [MHz], and in the mixture that the burned material of rice bran performed pulverization treatment (RBC) and the stainless (SUS) fiber are at 25 [wt. %] each, the electric field shielding effectiveness is a value of approx. 40 [dB] or above on average up to frequencies of about 1000 [MHz], and is approx. 30 [dB] as the minimum value.

Here, in the battery pack cover for a car and the undercover for a car, in general, in the frequency band of 100 [MHz] to 2 [GHz], the electric field shielding effectiveness approx. 60 [dB] or above is required. Therefore, in the sheet material according to Fig. 18 (a), except for the mixture that the burned material of rice bran performed pulverization treatment (RBC) and the stainless (SUS) fiber are at 25 [wt. %] each, and the mixture that the burned material of rice husk performed pulverization treatment (RHC) and the stainless (SUS) fiber are at 25 [wt. %] each, they can be used as the battery pack cover for a car, etc.

In addition, the conventional battery pack cover for a car is necessary troublesome production process to cover entire battery pack cover for a car, mainly by using stainless material as a mesh. However, the battery pack cover using the sheet material of the present embodiment is possible to adopt a simplified production method to mold integrally by prepare a metal mold, etc. in accordance with the shape, size of battery pack for a car. Also, the battery pack cover using the sheet material of the present embodiment, as a result containing burned plant material, it is also possible to achieve weight reduction compared to conventional battery pack cover for a car since the ratio of stainless material can be reduced relatively.

Furthermore, generally, since the stainless material used in conventional battery pack for a car is expensive compared to the burned plant material, there is the advantage that the battery pack cover for a car mixed with burned plant material becomes inexpensive

See Fig. 18 (b), compared to Fig. 17 (b), generally, it is found that the magnetic field shielding effectiveness is improved. In addition, from Fig. 18 (a) and Fig. 18 (b), it is found that there is an affinity for the electric field shielding effectiveness and the magnetic field shielding effectiveness. That is, for the mixture which the burned material of rice husk performed pulverization treatment (RHC) and the stainless (SUS) fiber are at 25 [wt. %] each, the magnetic field shielding effectiveness and the electric field shielding effectiveness are slightly less than the others, and for the mixture which the burned material of rice bran performed pulverization treatment (RBC) and the stainless (SUS) fiber are at 25 [wt. %] each, the magnetic field shielding effectiveness and the electric field shielding effectiveness are slightly less than the others further.

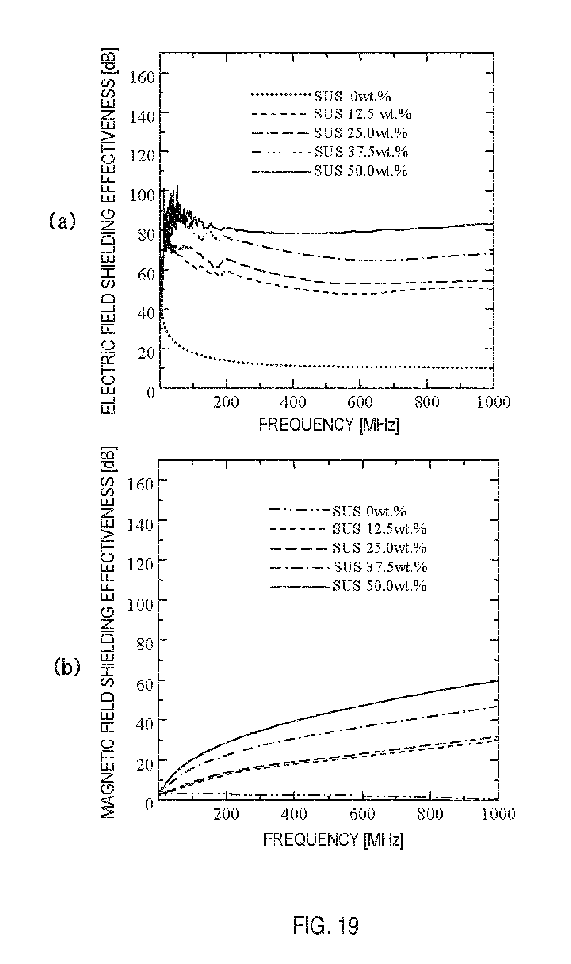

Fig. 19 is figures showing the measurement results of the electromagnetic shielding effectiveness of the sheet material according to 3^{rd} category. That is, the sheet material is selectively mixed with stainless (SUS) fiber against burned material of cacao husk performed pulverization treatment. Fig. 19 is corresponding to Fig. 17.

As apparent from Fig. 19 (a), compared to Fig. 17 (a), generally, it is found that the electric field shielding effectiveness is improved. In addition, please note that the graph at the bottom in Fig. 19 (a) is also shown in Fig. 17 (a).

See Fig. 19 (a), if the mixing ratio of stainless (SUS) fiber is increased more, the electric field shielding effectiveness is improved more. Even if the mixing ratios of the burned material of cacao husk performed pulverization treatment (CHC) and the stainless (SUS) fiber against the entire sheet material are respectively 12.5 [wt. %] and 37.5 [wt. %], the electric field shielding effectiveness of 60 [dB] or above required for above-described battery pack cover for a car, etc. can be achieved.

See Fig. 19 (b), compared to Fig. 17 (b), generally, it is found that the magnetic field shielding effectiveness is improved. In addition, from Fig. 19 (a) and Fig. 19 (b), it is found that there is an affinity for the electric field shielding effectiveness and the magnetic field shielding effectiveness.

In addition, the things which the mixing ratios of the burned material of cacao husk and the stainless (SUS) fiber against the entire sheet material are respectively 10 [wt. %], 30 [wt. %], 50 [wt. %], and the mixing ratio of the burned material of cacao husk and the stainless (SUS) fiber is 1;1, and the thing that the mixing ratio of the burned material of cacao husk against the entire sheet material is 50 [wt. %] (no SUS fiber) are respectively produced, and the electromagnetic shielding effectiveness is measured by dual focus flat cavity (DFFC) method in addition to KEC method.

As a result, in the case of KEC method, the thing of "10 [wt. %]" is approx. 45 [dB] on average, the thing of "30 [wt. %]" is approx. 80 [dB] on average, the thing of "50 [wt. %]" is approx. 105 [dB] on average, the thing of "50 [wt. %] (no SUS fiber)" is approx. 30 [dB] on average as the electric field shielding effectiveness.

In addition, DFFC method, although it is measured in the range of 1 [MHz] to 9 [MHz], the thing of "10 [wt. %]" is approx. 40 [dB] on average, the thing of "30 [wt. %]" is approx. 75 [dB] on average, the thing of "50 [wt. %]" is approx. 95 [dB] on average, the thing of "50 [wt. %] (no SUS fiber)" is approx. 20 [dB] on average as the electromagnetic shielding effectiveness.

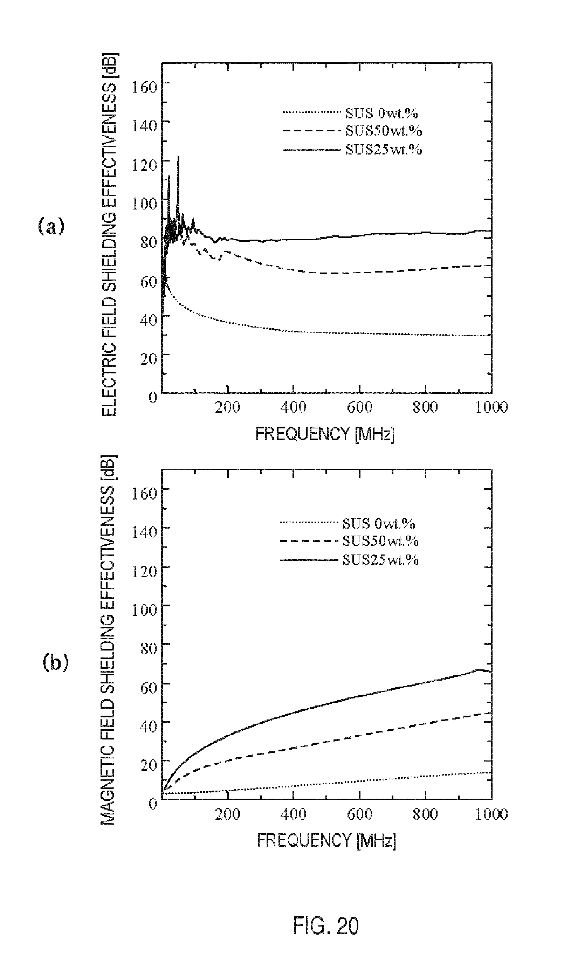

Fig. 20 is figures showing the measurement results of the electromagnetic shielding effectiveness of the sheet material according to 4^{th} category. That is, the sheet material is selectively mixed with stainless (SUS) fiber against burned material of cacao husk without performing the pulverization treatment. Fig. 20 is corresponding to Fig. 17.

As apparent from Fig. 20 (a), compared to Fig. 17 (a), generally, it is found that the electric field shielding effectiveness is improved. Surprisingly, even if the stainless (SUS) fiber is not mixed completely, it was 30 [dB] or above in the frequency band up to 1000 [MHz].

Furthermore, surprisingly, the electric field shielding effectiveness of the mixture of the burned material of cacao husk without performing the pulverization treatment and the stainless (SUS) fiber is more increased than that of the single substance of stainless (SUS) fiber. Therefore, for example, when such a sheet material is used as an inspection equipment such as an electronic device, near ETC gate, building materials such as a roof material, a floor material or a wall material, work shoes, work clothes, a helmet, and a battery pack cover for a car, the excellent effect such as lightweight and inexpensive, and moreover, realization of simplified production process can be achieved.

See Fig. 20 (b), compared to Fig. 17 (b), generally, it is found that the magnetic field shielding effectiveness is improved. In addition, from Fig. 20 (a) and Fig. 20 (b), it is found that there is an affinity for the electric field shielding effectiveness and the magnetic field shielding effectiveness.

As described above, in the present embodiment, although the explanation of the measuring result based on KEC method is mainly performed, as described in Embodiment 1, when the electromagnetic shielding characteristic of sheet material based on Advantest method is measured, it is confirmed that similar result can be obtained.

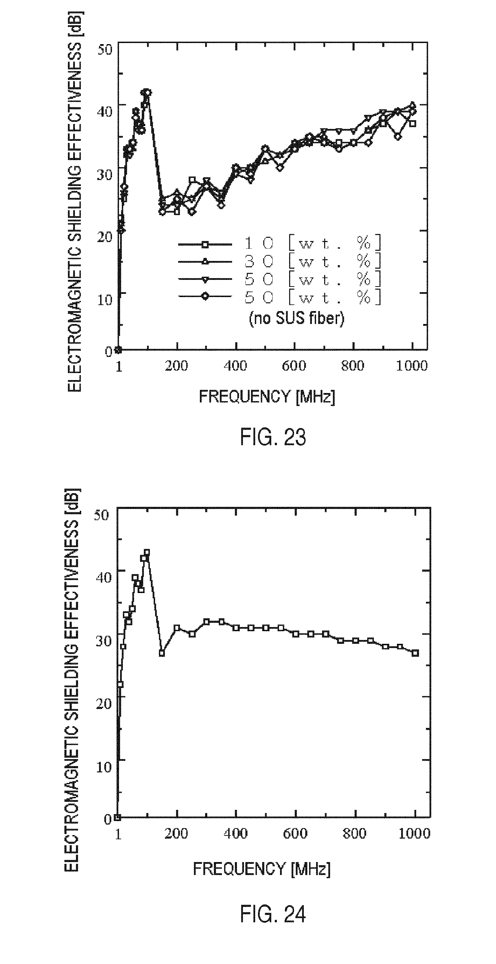

Fig. 23 is a figure showing the electromagnetic shielding characteristic of the sheet material consisting of the mixture of the burned plant material of the present embodiment and SUS fiber measured based on the arch test method. The lateral axis and vertical axis of Fig. 23 respectively represent the frequency [MHz] and the electromagnetic shielding effectiveness [dB].

In this case, for comparison, the electromagnetic shielding characteristic for the laminate consisting of the sheet material produced from a single substance of stainless (SUS) fiber and the sheet material produced from a single substance of burned plant material is also studied. In addition, the things which the mixing ratios of the burned material of cacao husk and the SUS fiber against the entire sheet material are respectively 10 [wt. %], 30 [wt. %], 50 [wt. %], and the mixing ratio of the burned material of cacao husk and the SUS fiber is 1;1, and the thing which the mixing ratio of the burned material of cacao husk against the entire sheet material is 50 [wt. %] (no SUS fiber) are respectively produced.

According to Fig. 23, it is found that the electromagnetic shielding characteristic of the sheet material of the present embodiment is obtained high electromagnetic shielding effectiveness 40 [dB] or above at around 100 [MHz] and at around 1000[MHz] without depending on the mixing ratio of the burned material of cacao husk and the SUS fiber against the entire sheet material. Therefore, if there is a request of sheet material which is excellent electromagnetic shielding effectiveness, the burned material of cacao husk is not required so many mixed amount.

Fig. 24 is a figure showing the electromagnetic shielding characteristic for the laminate consisting of the sheet material produced from a single substance of SUS fiber and the sheet material produced from a single substance of burned plant material measured based on the arch test method as a comparative example. The lateral axis and vertical axis of Fig. 24 respectively represent the frequency [MHz] and the electromagnetic shielding effectiveness [dB].

As shown in Fig. 24, in the frequency 1000 [MHz] or below, it is found that the electromagnetic shielding effectiveness can be realized approx. 30 [dB] as an average.

However, as obvious when comparing with Fig. 23, in the case of the sheet material of the comparative example, the electromagnetic shielding effectiveness more than 40 [dB] is confirmed only around 100 [MHz], it is less than 30 [dB] around 1000 [MHz].

To summarize the above, by comparing Fig. 23 and Fig. 24, regarding the sheet material, it can be seen that the electromagnetic shielding effectiveness of those mixed the burned plant material and the SUS fiber at the time of producing is increased more than that of those laminated simply ones produced from a single substance of burned plant material and ones produced from a single substance of SUS fiber. In other word, the sheet material of the present embodiment can obtain excellent electromagnetic shielding effectiveness since it is produced in a state in which the burned plant material and the SUS fiber are mixed.

Furthermore, the sheet material of the present embodiment can be suitably used for an electromagnetic shielding member. More specially, it is possible to produce the electromagnetic shielding member which is laminated so that the sheet material formed by mixing of the burned plant material and SUS fiber is outside and the sheet material produced from a single substance of burned plant material is inside. In addition, a insulating layer, optionally, may be provided on the surface of the outer sheet material. In this way, by covering an electromagnetic wave source with an electromagnetic shielding member, it becomes possible that an electromagnetic wave from the electromagnetic wave source does not leak to the outside. In such case, since the inner sheet material mainly contributes to the electric field absorption and the outer sheet material mainly contributes to the magnetic field shielding, the electromagnetic wave in the electromagnetic shielding member can be reduced. Furthermore, when the insulating layer is provided, it can be prevented that the electromagnetic wave which could not be shielded by each of the sheet material is irradiated to the outside of the electromagnetic shielding member. As an example of the use of this kind of electromagnetic shielding member, above-described inspection equipment such as electronic device, battery pack cover for a car, etc. can be mentioned.

In addition, the above-mentioned each sheet material can also be reversed. That is, it is possible to produce the electromagnetic shielding member which is laminated so that the sheet material formed by mixing the burned plant material and SUS fiber is inside and the sheet material produced from a single substance of burned plant material is outside. In this way, by covering a prevention object of electromagnetic wave irradiation with an electromagnetic shielding member, it can be avoided that electromagnetic waves from the electromagnetic wave source located outside is irradiated to the prevention object. In this case, since the outer sheet material mainly contributes to the electric field adsorption, the electromagnetic shielding member not only has merely an electromagnetic shielding function but also it is possible to avoid an adverse effect to the electronic device, etc. located around the electromagnetic shielding member. As an example of the use of this kind of electromagnetic shielding member, above-described building material, clothing, etc. can be mentioned.

### (Embodiment 3)

In Embodiment 3 of the present invention, at the time of the pressing process which is performed during the production of sheet material, the pressurizing conditions are changed.

**Table 3**

| Composition | Cacao husk formed sheet | | | | | | SUS fiber + Cacao husk formed sheet | | | | | |
|---|---|---|---|---|---|---|---|---|---|---|---|---|
| Cacao husk (150-250 *µ*m) | 10 | | 30 | | 50 | | 5 | | 15 | | 25 | |
| SUS fiber | 0 | | | | | | 5 | | 15 | | 25 | |
| Paper weight [g/mm²] | 2000 | | | | | | | | | | | |
| Pressurization | low p | high p | low p | high p | low p | high p | low p | high p | low | high p | p low p | high p |
| Bulk density [g/cm3] | 0.86 | 1.01 | 0.8 | 1.07 | 0.71 | 1.09 | 0.84 | 1.04 | 0.77 | 1.22 | 0.58 | 1.37 |
| Thickness [mm] | 2.4 | 2 | 2.6 | 1.9 | 2.9 | 1.9 | 2.4 | 1.8 | 2.7 | 1.6 | 3.3 | 1.4 |

Table 3 shows the relationship between the bulk density and the thickness of the sheet material which is produced by performing a pressurization of about 3 MPa and the sheet material which is produced by performing a pressurization of about 10 MPa during the pressing process which is performed after passing through the wet-process sheet production process and the drying process. In addition, as for the reason of "about 10 MPa", it is because this value is the press-pressurizing value for the close packing.

The production method of the sheet material of the present embodiment is the same as that of Embodiment 1 except for the pressurizing condition, the burning temperature of each burned plant material is set to 900 [°C]. In addition, in the present embodiment, it will be explained about the sheet material which is produced by the addition of stainless fiber selectively against burned material of cacao husk without performing the pulverization treatment.

As shown in Table 3, in the case of no addition of stainless fiber, the mixing ratios of the burned material of cacao husk without performing the pulverization treatment against the entire sheet material are respectively 10 [wt. %], 30 [wt. %] and 50 [wt. %].

On the other hand, in the case of addition of stainless fiber, the mixing ratios of the burned material of cacao husk without performing the pulverization treatment and the stainless fiber against the entire sheet material are respectively 10 [wt. %], 30 [wt. %] and 50 [wt. %].

Against the above 6 patterns samples, when the pressurization is performed at about 3 MPa and when the pressurization is performed at about 10 MPa, in both cases, the bulk density is increased more at the pressurization of about 10 MPa. In addition, along with this, the thickness of sheet material is also reduced. For the specific numerical values of bulk density and thickness of the sheet material, refer to Table 3.

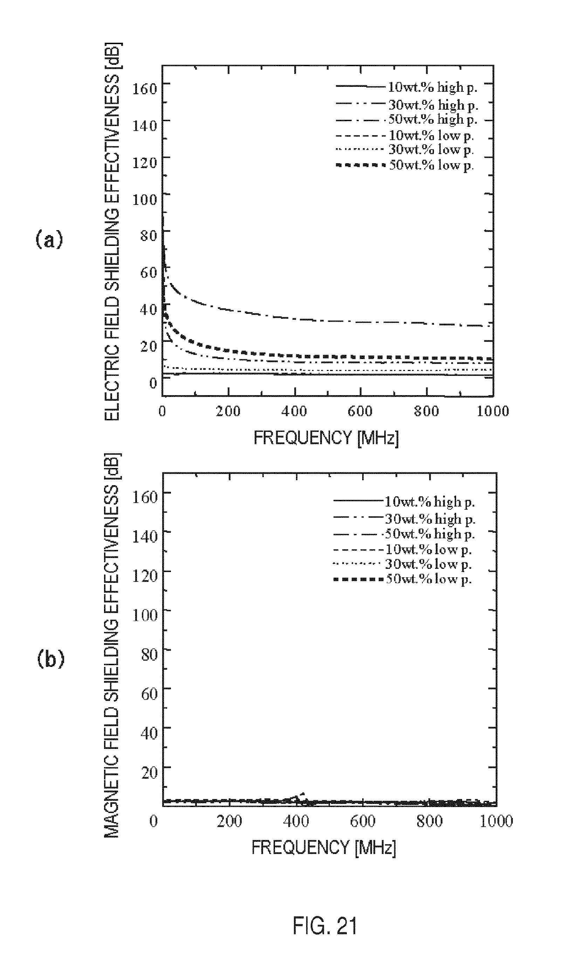

Fig. 21 is figures showing the measurement results of the electromagnetic shielding effectiveness of the sheet material without addition of stainless fiber against burned material of cacao husk without performing the pulverization treatment. This measurement is performed by KEC method, the lateral axis and vertical axis of Fig. 21 (a) respectively represent the frequency [MHz] and the electric field shielding effectiveness [dB]. In addition, the lateral axis and vertical axis of Fig. 21 (b) respectively represent the frequency [MHz] and the magnetic field shielding effectiveness [dB]. Further, "high p" in Fig. 21 means that the pressurization in Table 3 is "high", and "low p" means that the pressurization in Table 3 is "low".

According to Fig. 21 (a), in the case of no addition of stainless fiber, with increasing the mixing ratio of burned material of cacao husk without performing the pulverization treatment against the sheet material, the electric field shielding effectiveness is increased by performing the high pressurization. However, in the case that the mixing ratio of burned material of cacao husk without performing the pulverization treatment is 10 [wt. %], the clear difference of electric field shielding effectiveness by the high and low of pressurization is not observed.

According to Fig. 21 (b), the clear difference of magnetic field shielding effectiveness by the high and low of mixing ratio of burned material of cacao husk without performing the pulverization treatment and by the high and low of pressurization is not observed.

When the bulk density is increased, since the distance between powder of burned material of cacao husk is shortened, since the powder of burned material of cacao husk and the stainless fiber come into contact, and since the distance between stainless fibers is shortened, as the result that the electrical conductivity is increased, the electric field shielding property of sheet material is improved. In addition, even after performing a pressurization of 10 MPa, since a space is remaining inside of sheet material, the possibility that the spiral structure is destroyed is small.

Furthermore, when attention is paid to the lower limit value of bulk density, although the bulk density is about 0.3 [g/cm³] during the paper making process which is the production process of sheet material, in order to prevent the detachment of powder of burned material of cacao husk, once melted the surface of sheet material, the bulk density becomes about 0.5 [g/cm³]. In other word, the sheet material of the present embodiment may be pressurized under conditions that the bulk density becomes about 0.5 [g/cm³] at least.

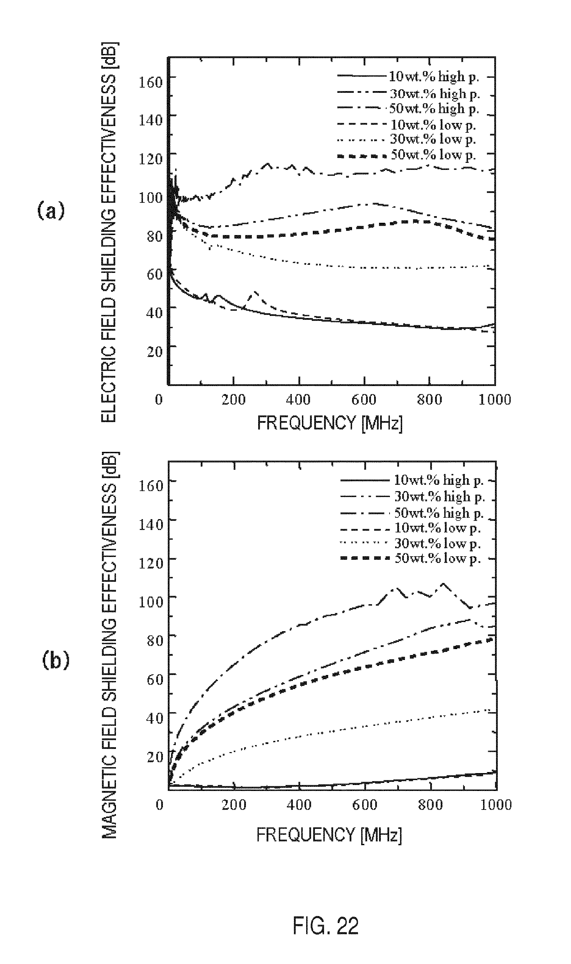

Fig. 22 is figures showing the measurement results of the electromagnetic shielding effectiveness of the sheet material with addition of stainless fiber against burned material of cacao husk without performing the pulverization treatment, it is corresponding to Fig. 21.

According to Fig. 22 (a), in the case of addition of stainless fiber, with increasing the mixing ratio of burned material of cacao husk without performing the pulverization treatment, the electric field shielding effectiveness is increased by performing the high pressurization. However, in the case that the mixing ratio of burned material of cacao husk without performing the pulverization treatment is 10 [wt. %], the clear difference of electric field shielding effectiveness by the high and low of pressurization is not observed. On the other hand, in the case of the best condition, the electric field shielding effectiveness more than 100 [dB] or approaching to 120 [dB] is obtained.

According to Fig. 22 (b), in the case of addition of stainless fiber against burned material of cacao husk without performing the pulverization treatment, with increasing the mixing ratio of burned material of cacao husk without performing the pulverization treatment, the electric field shielding effectiveness is increased by performing the high pressurization. In particular, the electric field shielding effectiveness is increased dramatically compared to those shown in Fig. 17 (b) and Fig. 18 (b).

As described above, summarizing the various measurement results, the sheet materials of Embodiment 2 and 3 are the following properties.
(1) For the sheet material using the mixture of SUS fiber and burned plant material, the electromagnetic shielding effectiveness is increased more if the ratio of SUS fiber is increased more, however the cost is increased. At market prices, the cost of SUS fiber is about 5 to 6 times of the cost of burned plant material. Thus, although the electric field shielding effectiveness required by applications of the sheet material is not necessarily constant, for the mixture of SUS fiber and burned plant material, 1 : 3 to 3 : 1 is generally good.
(2) If the mixing ratio of SUS fiber and burned plant material against the sheet material is increased more, the electromagnetic shielding effectiveness of sheet material is increased more.
(3) Without increasing the mixing ratio of SUS fiber and burned plant material against the sheet material, if the bulk density is increased by pressurization during the production of the sheet material, the electromagnetic shielding effectiveness of sheet material is increased.

### (Embodiment 4)

In Embodiment 1, although an example that the cacao husk after burning is pulverized then is introduced in an agitated vessel with propeller impeller is explained, in this embodiment, a sheet material produced by the process that the cacao husk before burning is pulverized, after that, is performed burning treatment is explained. In addition, as a mill, general-purpose cutter mill is used.

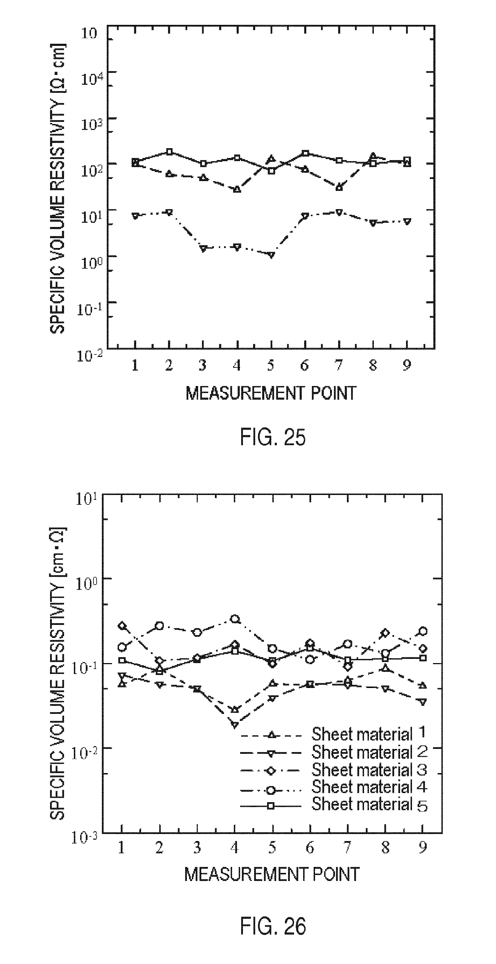

Fig. 25 is a figure showing the measurement results of the specific volume resistivity of the sheet material consisting of cacao husk which is burned after performing the pulverization process. This measurement is performed by using a low resistivity meter (Loresta-GP, MCP-610 manufactured by Mitsubishi Chemical Co. Ltd.). The measurement objects of the specific volume resistivity are both of the sheet material used those that passed through a mesh of a 500 µm by 500 µm wire mesh, etc. (plotted by Δ), and the sheet material used those that did not pass through it (plotted by ∇). In addition, for reference, Fig. 25 also shows the specific volume resistivity of the sheet material produced by the process in Fig.1 (however, without performing the pulverization process), (plotted by □).

First, in the case of the sheet material used those that passed through the mesh, there is no significant change in the specific volume resistivity even compared with the sheet material produced by the process in Fig. 1 (however, without performing the pulverization process), In either case, it is considered due to the relatively small spiral portion of the cacao husk occupied in the sheet material.

On the other hand, in the case of the sheet material used those that did not pass through the mesh, a decrease of one or two orders is seen in the specific volume resistivity. Since the cacao husk which did not pass through the mesh contains relatively many spiral portion, it is considered due to said portion.

Therefore, in the field that low specific volume resistivity is required, the sheet material consisting of the cacao husk which does not pass through the mesh, that is, the cacao husk which contains relatively many spiral portion may be used.

### (Embodiment 5)

Next, the sheet material which is mixed various matrices at the time of production is explained. In this case, in addition to measuring the conduction characteristic and the electromagnetic shielding characteristic of the sheet material of 80 mm square produced using polypropylene (PP), high molecular polyethylene (HDPE) as a matrix and glass fiber (GF) as a fibrous material, the tensile test is performed. Specific production conditions of the sheet material are as follows. In addition, for comparison, following Sheet material 5 does not contain a matrix.

Sheet material 1 (thickness t = 1.5 mm)
SUS fiber: 15 wt. %
Cacao husk (150 µm or below): 15 wt. %
Polyethylene fiber: 60 wt. %
GF (glass fiber): 10 wt. %
Paper weight in gsm: 2000 g/m²

Sheet material 2 (thickness t = 1.4 mm)
SUS fiber: 15 wt. %
Cacao husk (150 µm or below): 15 wt. %
Polyethylene fiber: 40 wt. %
GF (glass fiber): 30 wt. %
Paper weight in gsm: 2000 g/m²

Sheet material 3 (thickness t = 1.6 mm)
SUS fiber: 15 wt. %
Cacao husk (150 µm or below): 15 wt. %
PP (polypropylene): 60 wt. %
Aramid fiber: 10 wt. %
Paper weight in gsm: 2000 g/m²

Sheet material 4 (thickness t = 1.6 mm)
SUS fiber: 15 wt. %
Cacao husk (150 µm or below): 15 wt. %
HDPE (high density polyethylene): 60 wt. %
Aramid fiber: 10 wt. %
Paper weight in gsm: 2000 g/m²

Sheet material 5 (thickness t = 1.6 mm)
SUS fiber: 15 wt. %
Cacao husk (150 µm or below): 15 wt. %
Matrix: None
Polyethylene fiber: 60 wt. %
Aramid fiber: 10 wt. %
Paper weight in gsm: 2000 g/m²

Fig. 26 is a figure showing the specific volume resistivity of Sheet material 1 to Sheet material 5. According to Fig. 26, although the change based on the presence or absence of matrix and the type is not seen much, nevertheless, Sheet material 1 and 2 including glass fiber as a matrix show slightly low specific volume resistivity compared to others.

For reference, the average values of the specific volume resistivity of Sheet material 1 to Sheet material 5 are respectively 5.96x10⁻² Ω·cm, 4.90x10⁻² Ω·cm, 2.00x10⁻¹ Ω·cm, 1.57x10⁻¹ Ω·cm and 1,16x10⁻¹ Ω·cm.

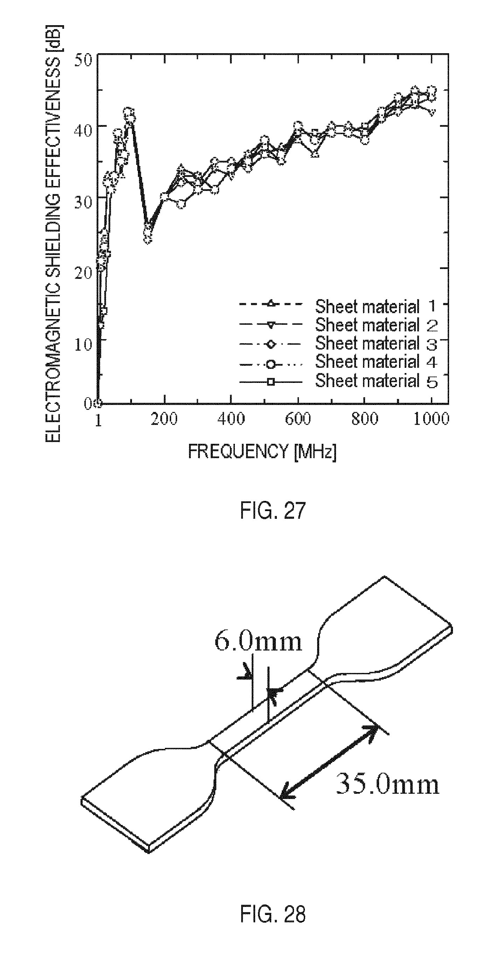

Fig. 27 is a figure showing the electromagnetic shielding effectiveness of Sheet material 1 to Sheet material 5. As shown in Fig. 27, the electromagnetic shielding effectiveness of Sheet material 1 to Sheet material 5 is almost the same value 1000 [MHz] or below, even include a particular matrix, the difference between others is not seen.

Fig. 28 is a schematic diagram of workpiece for tensile test of Sheet material 1 to Sheet material 5. As shown in Fig. 28, this workpiece has the conditions that the central portion is about 6.0 mm in width, the length is 35.0 mm and the both ends are sufficient area. The tests of tensile strength [MPa] and tensile elasticity [MPa] are performed by using these workpieces.

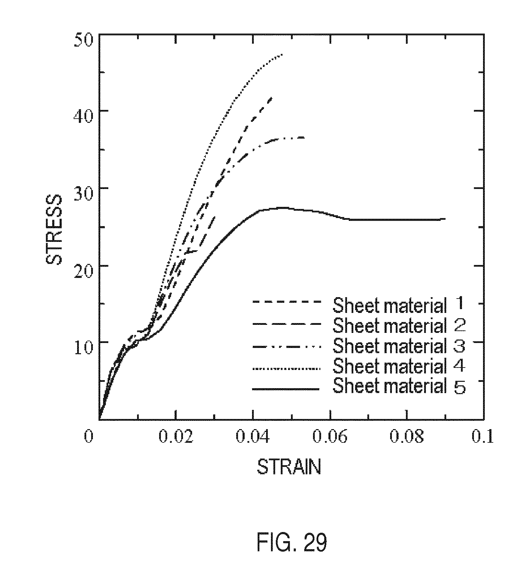

Fig. 29 is a figure showing the test results of tensile test of Sheet material 1 to Sheet material 5. The lateral axis and vertical axis of Fig. 29 respectively represent the strain and the stress. First, focusing on the length of each graph in Fig. 29, the graph length of Sheet material 5 is significantly longer as compared to the graph length of the other sheet material. From this, when the matrix is mixed, it is found that the fracture ductility is reduced. In addition, it is found that the graph length of Sheet material 2 is remarkably shorter than the graph length of the other sheet material. From this, when the mixed amount of the matrix is increased too much, it is found that the fracture ductility is reduced more.

Then, when looking at the stress of Sheet material 1 to 5 that the strain corresponds to "0.02" for example, the graph position of the other sheet material is more above than the graph position of Sheet material 5. From this, when the matrix is mixed, it is found that the stress against the strain is improved.

**Table 4**

| Sheet material | Tensile strength [MPa] | tensile elasticity [MPa] |
|---|---|---|
| Sheet material 1 | 42.0 | 1483 |
| Sheet material 2 | 26.0 | 2065 |
| Sheet material 3 | 36.5 | 2044 |
| Sheet material 4 | 47.5 | 1942 |
| Sheet material 5 | 26.6 | 1541 |

Table 4 is a table showing the calculation results of the tensile strength [MPa] and the tensile elasticity [MPa] of Sheet material 1 to Sheet material 5. As shown in Table 4, since the tensile strength of Sheet material 1, 3 and 4 is improved, in general, the tensile strength is improved by mixing the matrix. However, from the fact that the tensile strength of Sheet material 2 is reduced, when the mixed amount of the matrix is increased too much, it is considered that the tensile strength is reduced.

From the above, in the fields that the high tensile strength, or, the stress against the strain are required, although it depends on applications of the sheet material, it is better to mix the appropriate amount of matrix. On the other hand, in the field that the high fracture ductility is required, although it depends on applications of the sheet material, it is better not to mix the matrix.

### INDUSTRIAL APPLICABILITY

The present invention has applicability in the field of electromagnetic shielding and in the field of electromagnetic wave absorption.

### BRIEF DESCRIPTION OF THE DRAWINGS

Fig. 1 shows a schematic production process diagram of the sheet material using the burned material of cacao husk.
Fig. 2 shows charts indicating the measurement results of the electromagnetic shielding characteristics of the sheet material produced through a pulverization process of burned material of cacao husk.
Fig. 3 shows charts indicating the measurement results of the electromagnetic shielding characteristics of the sheet material produced without going through a pulverization process of burned material of cacao husk.
Fig. 4 shows charts indicating the measurement results of the electromagnetic shielding characteristics of the sheet material produced through a pulverization process of burned material of soybean hulls.
Fig. 5 shows charts indicating the measurement results of the electromagnetic shielding characteristics of the sheet material produced without going through a pulverization process of burned material of soybean hulls.
Fig. 6 shows charts indicating the measurement results of the electromagnetic wave absorption characteristic of the sheet material produced through a pulverization process of burned material of cacao husk.
Fig. 7 shows charts indicating the measurement results of the electromagnetic wave absorption characteristic of the sheet material produced through a pulverization process of the burned material of rice husk.
Fig. 8 shows charts indicating the measurement results of the electromagnetic wave absorption characteristic of the sheet material produced by using the burned material of rice bran.
Fig. 9 shows charts indicating the results of component analysis based on the ZAF quantitative analysis method for cacao husk before and after burning.
Fig. 10 shows charts indicating the result of the component analysis based on the organic micro-elemental analysis method corresponding to Fig 9.
Fig. 11 shows a chart indicating the test results of the conductivity test regarding the burned material of cacao husk after pulverization.
Fig. 12 shows a chart indicating the relationship between the content ratio of the burned material of cacao husk kneaded into ethylene propylene diene terpolymer and the specific volume resistivity.
Fig. 13 shows SEM pictures of cacao husk before burning.
Fig. 14 shows SEM pictures of cacao husk before burning.
Fig. 15 shows SEM pictures of cacao husk burned without distinguishing by the inner skin and the outer skin.
Fig. 16 shows SEM pictures of cacao husk burned without distinguishing by the inner skin and the outer skin.
Fig. 17 is figures showing the measurement results of the electromagnetic shielding effectiveness of the sheet material according to 1^{st} category shown in Table 1.
Fig. 18 is figures showing the measurement results of the electromagnetic shielding effectiveness of the sheet material according to 2^{nd} category shown in Table 1, it is corresponding to Fig. 17.
Fig. 19 is figures showing the measurement results of the electromagnetic shielding effectiveness of the sheet material according to 3^{rd} category shown in Table 1.
Fig. 20 is figures showing the measurement results of the electromagnetic shielding effectiveness of the sheet material according to 4^{th} category shown in Table 2.
Fig. 21 is figures showing the measurement results of the electromagnetic shielding effectiveness of the sheet material without addition of stainless fiber against burned material of cacao husk without performing the pulverization treatment.
Fig. 22 is figures showing the measurement results of the electromagnetic shielding effectiveness of the sheet material with addition of stainless fiber against burned material of cacao husk without performing the pulverization treatment.
Fig. 23 is a figure showing the electromagnetic shielding characteristic of the sheet material consisting of the mixture of the burned plant material and SUS fiber measured based on the arch test method.
Fig. 24 is a figure showing the electromagnetic shielding characteristic for the laminate consisting of the sheet material produced from a single substance of SUS fiber and the sheet material produced from a single substance of burned plant material measured based on the arch test method as a comparative example.
Fig. 25 is a figure showing the measurement results of the specific volume resistivity of the sheet material consisting of cacao husk which was burned after performing the pulverization process. It is a figure showing the measurement results of the specific volume resistivity of the sheet material.
Fig. 26 is a figure showing the specific volume resistivity of Sheet material 1 to Sheet material 5.
Fig. 27 is a figure showing the electromagnetic shielding effectiveness of Sheet material 1 to Sheet material 5.
Fig. 28 is a schematic diagram of workpiece for tensile test of Sheet material 1 to Sheet material 5.
Fig. 29 is a figure showing the test results of tensile test of Sheet material 1 to Sheet material 5.

## Claims

1. A sheet material formed by a wet-process sheet production method from a mixture of burned plant material and fibrous material.

2. The sheet material as claimed in Claim 1, wherein the burned plant material is a burned material of rice husk, a burned material of rice bran, a burned material of soybean hulls, a burned material of rapeseed meal, a burned material of inner skin of peanut, a burned material of conduit side wall portion of seed plant, or a burned material of cacao husk.

3. The sheet material as claimed in Claim 1, wherein the burned plant material contains a spiral portion.

4. The sheet material as claimed in Claim 1, wherein the fibrous material is a thermoplastic resin fiber, a thermosetting resin fiber, a natural fiber, a semisynthetic fiber, a glass fiber, an inorganic fiber, a metal fiber, or one of these combinations.

5. The sheet material as claimed in Claim 1, in addition, wherein a metal filler is mixed.

6. The sheet material as claimed in Claim 1, wherein a mixing ratio of the fibrous material and the metal filler is 1 : 3 to 3 : 1.

7. The sheet material as claimed in Claim 1, wherein, after the wet-process sheet production, the sheet material is pressurized under a condition that a bulk density becomes 0.5 [g/cm³] or above.

8. The sheet material as claimed in Claim 1, wherein, in addition, a matrix consisting of a thermosetting resin, or, a thermoplastic resin is mixed.

9. A burned plant material included in the sheet material as claimed in Claim 1.

10. A method producing for a sheet material, wherein the method is to form a sheet by wet-process sheet production using a sheet making slurry obtained by mixing a fibrous material and a burned plant material in water.

11. An electromagnetic shielding member, wherein the electromagnetic shielding member consists of a sheet material using a burned plant material.

12. An electromagnetic shielding member consisting of a sheet material formed by a wet-process sheet production method from a mixture of burned plant material, fibrous material and metal filler.

13. An electromagnetic shielding member laminated a sheet material using a burned plant material and a sheet material formed by a wet-process sheet production method from a mixture of burned plant material, fibrous material and metal filler.
